# EUROPEAN PATENT APPLICATION

(11) **EP 4 592 907 A1**
(43) Date of publication of application: **30.07.2025**
(21) Application number: 25151348.7
(22) Date of filing: 10.01.2025
(51) Int. Cl.: G06N 7/01, G05B 13/04

(54) **DIGITAL TWIN CALIBRATION**

(30) Priority: 23.01.2024 US 202418420294
(71) Applicant: FEI Electron Optics B.V., 5651GG Eindhoven (NL)
(72) Inventor: JAVAHERI, Narjes, 5651GG Eindhoven (NL); SCHOENMAKERS, Remco Hubertus Maria, 5651GG Eindhoven (NL); PEEMEN, Maurice, 5651GG Eindhoven (NL); KOHR, Holger, 5651GG Eindhoven (NL); VANROMPAY, Hans Irma Stefaan, 5651GG Eindhoven (NL); DIEPHUIS, Maurits, 5651GG Eindhoven (NL)
(74) Representative: Boult Wade Tennant LLP

(57) **Abstract**

Systems or techniques are provided for facilitating improved digital twin calibration for scientific instruments. In various embodiments, a system can synchronize, via execution of a state-wide Bayesian filter, a parametric state of a digital twin with a physical state of a scientific instrument. In various instances, the state-wide Bayesian filter can comprise a set of calibration iterations, each of which can comprise a Bayesian update to an entirety of the parametric state based on an iteration-common observable that is exhibitable by the scientific instrument and simulatable by the digital twin. In various cases, the scientific instrument can be a charged-particle microscope, the parametric state of the digital twin can be an aberration coefficient vector of the charged-particle microscope, and the iteration-common observable can be a Fourier transform of a convergent beam electron diffraction pattern of an amorphous carbon specimen captured by the charged-particle microscope.

## Description

### BACKGROUND

Scientific instruments can comprise complex arrangements of actuatable parts, sensors, or consumables. Digital twins can simulate or forecast the behaviors of scientific instruments. In order for such simulating or forecasting to be accurate, digital twins should first be calibrated or synchronized with their respective scientific instruments.

### SUMMARY

The following presents a summary to provide a basic understanding of one or more embodiments. This summary is not intended to identify key or critical elements, or delineate any scope of the particular embodiments or any scope of the claims. Its sole purpose is to present concepts in a simplified form as a prelude to the more detailed description that is presented later. In one or more embodiments described herein, devices, systems, computer-implemented methods, apparatus or computer program products that facilitate improved digital twin calibration for scientific instruments are described.

According to one or more embodiments, a scientific instrument is provided. The scientific instrument can comprise a non-transitory computer-readable memory that can store computer-executable components. The scientific instrument can further comprise a processor that can be operably coupled to the non-transitory computer-readable memory and that can execute the computer-executable components stored in the non-transitory computer-readable memory. In various embodiments, the computer-executable components can comprise an access component that can access a digital twin of the scientific instrument. In various aspects, the computer-executable components can comprise a calibration component that can synchronize, via execution of a state-wide Bayesian filter, a parametric state of the digital twin with a physical state of the scientific instrument. In various instances, the state-wide Bayesian filter can comprise a set of calibration iterations, each of which can comprise a Bayesian update to an entirety of the parametric state based on an iteration-common observable that is exhibitable by the scientific instrument and simulatable by the digital twin.

According to one or more embodiments, a computer-implemented method is provided. In various embodiments, the computer-implemented method can comprise synchronizing, by a device operatively coupled to a processor that executes a state-wide Bayesian filter, a parametric state of a digital twin with a physical state of a scientific instrument. In various aspects, the computer-implemented method can comprise generating, by the device and in response to the synchronizing, an electronic alert indicating that the digital twin is ready to forecast behavior of the scientific instrument. In various instances, the state-wide Bayesian filter can comprise a set of calibration iterations, each of which can comprise a Bayesian update to an entirety of the parametric state based on an iteration-common observable that is exhibitable by the scientific instrument and simulatable by the digital twin.

According to one or more embodiments, a computer program product for facilitating improved digital twin calibration for scientific instruments is provided. In various embodiments, the computer program product can comprise a non-transitory computer-readable memory having program instructions embodied therewith. In various aspects, the program instructions can be executable by a processor to cause the processor to access a digital twin of a charged-particle microscope. In various instances, the program instructions can be further executable to cause the processor to synchronize a parametric state of the digital twin with a physical state of the charged-particle microscope, via execution of a set of calibration iterations, each of which can comprise a Bayesian update to an entirety of the parametric state based on an iteration-common observable that is exhibitable by the charged-particle microscope and simulatable by the digital twin. In various cases, the program instructions can be further executable to cause the processor to forecast, by running the digital twin after synchronization, how the charged-particle microscope would respond to a proposed usage scenario.

### DESCRIPTION OF THE DRAWINGS

Various embodiments will be readily understood by the following detailed description in conjunction with the accompanying figures. To facilitate this description, like reference numerals designate like structural elements. Embodiments are illustrated by way of example, not by way of limitation, in the figures. The figures are not necessarily drawn to scale.
FIG. 1 illustrates an example, non-limiting block diagram of a scientific instrument module in accordance with various embodiments described herein.
FIG. 2 illustrates an example, non-limiting flow diagram of a computer-implemented method in accordance with various embodiments described herein.
FIG. 3 illustrates a block diagram of an example, non-limiting scientific instrument that facilitates improved digital twin calibration in accordance with one or more embodiments described herein.
FIG. 4 illustrates an example, non-limiting block diagram showing a set of controllable instrument settings, a parametric state, a set of input variables, and a set of output variables in accordance with one or more embodiments described herein.
FIG. 5 illustrates a block diagram of an example, non-limiting scientific instrument including a state-wide Bayesian filter and a calibrated parametric state instantiation that facilitates improved digital twin calibration in accordance with one or more embodiments described herein.
FIG. 6 illustrates an example, non-limiting block diagram showing a state-wide Bayesian filter in accordance with one or more embodiments described herein.
FIGs. 7-12 illustrate example, non-limiting block diagrams showing an iteration of a state-wide Bayesian filter in accordance with one or more embodiments described herein.
FIGs. 13-15 illustrate flow diagrams of example, non-limiting computer-implemented methods that facilitate improved digital twin calibration in accordance with one or more embodiments described herein.
FIGs. 16-22 illustrate example, non-limiting diagrams of experimental results in accordance with one or more embodiments described herein.
FIG. 23 illustrates an example, non-limiting block diagram of a graphical user interface that can be used in the performance of some or all of the methods or techniques disclosed herein, in accordance with various embodiments described herein.
FIG. 24 illustrates an example, non-limiting block diagram of a computing device that can perform some or all of the methods or techniques disclosed herein, in accordance with various embodiments described herein.
FIG. 25 illustrates an example, non-limiting block diagram of a scientific instrument support system in which some or all of the methods or techniques disclosed herein may be performed, in accordance with various embodiments described herein.
FIG. 26 illustrates a block diagram of an example, non-limiting operating environment in which one or more embodiments described herein can be facilitated.
FIG. 27 illustrates an example networking environment operable to execute various implementations described herein.

### DETAILED DESCRIPTION

The following detailed description is merely illustrative and is not intended to limit embodiments or application/uses of embodiments. Furthermore, there is no intention to be bound by any expressed or implied information presented in the preceding Background or Summary sections, or in the Detailed Description section.

One or more embodiments are now described with reference to the drawings, wherein like referenced numerals are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Various operations can be described as multiple discrete actions or operations in turn, in a manner that is most helpful in understanding the subject matter disclosed herein. However, the order of description should not be construed as to imply that these operations are necessarily order dependent. In particular, these operations can be performed in an order different from the order of presentation. Operations described can be performed in a different order from the described embodiments. Various additional operations can be performed, or described operations can be omitted in additional embodiments.

Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices. As used herein, the phrase "based on" should be understood to mean "based at least in part on," unless otherwise specified.

A scientific instrument (e.g., mass spectrometer, electron microscope) can be any suitable computerized device that can capture electronic measurements in a scientific, laboratory, research, or clinical operational context. A scientific instrument can comprise a complex arrangement of actuatable parts (e.g., ion sources, ion lenses, heaters, coolers, fluid valves, fluid pumps, circuit switches, specimen stages, apertures), sensors (e.g., ion detectors, voltmeters, thermistors, potentiometers, pressure gauges), or consumables (e.g., carrier fluids, calibrants, filters).

A digital twin of a scientific instrument can be any suitable collection of mathematical or physics-based models (e.g., mass continuity formulas, energy conservation formulas) that can collectively simulate or forecast a future behavior of the scientific instrument (e.g., that can compute how the scientific instrument's complex arrangement of actuatable parts, sensors, or consumables, or any portion thereof, will be impacted by any given planned or proposed use of the scientific instrument). In order for the digital twin to accurately or properly facilitate such simulation or forecasting, the digital twin should first be calibrated or otherwise synchronized with the scientific instrument. In other words, whatever parameters that make up or define the digital twin should be assigned numerical values that closely align with whatever physical characteristics of the scientific instrument that those parameters represent. If the numerical values assigned to the parameters of the digital twin do not closely align with the physical characteristics of the scientific instrument, the simulations or forecasts computed by the digital twin can fail to accurately reflect the behavior of the scientific instrument.

Various parameters often represent or quantify physical characteristics of the scientific instrument that are not directly controllable or selectable (e.g., a damping coefficient can represent a type of physical characteristic of a scientific instrument that affects how the scientific instrument kinetically or kinematically responds to different inputs, but the scientific instrument generally does not have any button, knob, joystick, or other interface device that allows for direct selection of damping coefficients). Accordingly, calibration of such parameters can involve performing experiments or tests on the scientific instrument, so as to estimate or infer what numerical values those parameters should be assigned.

As the inventors of various embodiments described herein recognized, existing techniques facilitate calibration of digital twin parameters in a piecemeal and non-standardized fashion. In particular, when given a digital twin having a total set of parameters, existing techniques break that total set of parameters up into disjoint subsets, identify which of those subsets depend on which others of those subsets, and calibrate those subsets in order of dependency by using subset-specific testing procedures.

For example, consider a digital twin whose total set of parameters are: instrument length, width, and height; instrument stiffness and yield strength; and instrument damping coefficients. In such case, existing techniques would involve determining that: stiffness and yield strength can be experimentally estimated once geometry is known; and damping coefficients can be experimentally estimated once stiffness, yield strength, and geometry are known. Accordingly, such existing techniques would first measure the length, width, and height of the scientific instrument and assign those measured values to the length, width, and height parameters of the digital twin. Such existing techniques would then estimate the stiffness and yield strength of the scientific instrument by performing one or more load-displacement tests on the scientific instrument (e.g., the data collected from those load-displacement tests can be statistically processed in conjunction with the measured geometry to compute the stiffness and yield strength), and those estimates would then be assigned to the stiffness and yield strength parameters of the digital twin. Finally, such existing techniques would estimate the damping coefficients of the scientific instrument by performing one or more vibration tests or initial condition tests on the scientific instrument (e.g., the data collected from those vibration or initial condition tests can be statistically processed in conjunction with the measured geometry and the estimated stiffness and yield strength to compute the damping coefficients), and those estimates would then be assigned to the damping coefficient parameters of the digital twin. Note that such existing techniques perform calibration in order of parameter dependency (e.g., the geometry parameters are calibrated first; the stiffness and yield strength parameters depend upon the geometry parameters and thus are calibrated only after the geometry parameters are calibrated; the damping coefficient parameters depend upon the geometry parameters and the stiffness and yield strength parameters and are thus calibrated only after the geometry parameters and the stiffness and yield strength parameters are calibrated). Furthermore, note that such existing techniques use a different or unique test, metric, or observable for each identified parameter subset (e.g., the geometry parameters are directly measured; the stiffness and yield strength parameters are estimated via load-displacement metrics; the damping coefficient parameters are estimated via vibration metrics).

Unfortunately, such existing techniques suffer from various disadvantages.

First, as the present inventors realized, such existing techniques are not generalizable beyond simplistic, well-behaved parameters. Indeed, such existing techniques are usable only for digital twin parameters that are uncomplicated, that are not intricately intertwined, or that otherwise have interrelationships that are easily or clearly understood. Simple parameters that are readily physically intuitive (such as geometry, stiffness, yield strength, or damping coefficients) satisfy these conditions. But more complicated parameters that are not readily physically intuitive (such as optical aberration coefficients; or elements or portions of a quantum Hamiltonian) do not satisfy these conditions. In the realm of scientific instruments, digital twins often have very many (e.g., tens, hundreds, or even thousands of) parameters that have high-dimensional, obscure, or otherwise counterintuitive or not well understood interdependencies among each other. Existing techniques cannot be confidently applied in such situations. After all, if it is unclear which parameters depend upon which, it cannot be known in what sequential order to calibrate the parameters according to existing techniques.

Moreover, such existing techniques are vulnerable to what the present inventors call the parameter ambiguity problem. Specifically, the present inventors recognized that, when calibrating the parameters of a digital twin by performing experiments or tests on a scientific instrument, it is possible that the parameters of the digital twin have or appear to have intrinsic symmetries, such that multiple different instantiations of the parametric state of the digital twin correspond or seem to correspond to the same obtained or measured experimental or test results. Indeed, in some cases, the underlying mathematical or physics-based theory of the digital twin can cause there to be multiple parametric state instantiations that actually correspond to a given experimental result; in other cases, noisy experimental measurements can make it seem as though multiple parametric state instantiations correspond to a given experimental result. In any case, it is possible that there is more than one way to calibrate the parameters of the digital twin so as to be in accordance with experimental or test results, notwithstanding that there is only one way to calibrate the parameters of the digital twin so as to match the true physical state of the scientific instrument.

Existing techniques do not recognize or mention the parameter ambiguity problem. Furthermore, as the present inventors realized, existing techniques are unable to reliably handle or address the parameter ambiguity problem. Indeed, when there are multiple possible instantiations of the parametric state that correspond to experimental or test results, dependency-ordered calibration using different test metrics for different parameters can be considered as prematurely or arbitrarily locking the digital twin into one of those possibilities without good reason (e.g., without even realizing or knowing that there are multiple other possibilities to choose from). In other words, which of those multiple possible instantiations of the parametric state is decided upon or chosen by existing techniques can be a function of the arbitrary order in which the parameters of the digital twin are calibrated.

For example, suppose that the parametric state of a digital twin of a scientific instrument is made up of a first parameter and a second parameter. Suppose that the first parameter is calibrated before the second parameter. In such case, an experiment corresponding or tailored to the first parameter can be performed on the scientific instrument, and the results of that experiment can suggest or indicate that the first parameter should be assigned a value A. Next, some other experiment corresponding or tailored to the second parameter can be performed on the scientific instrument, and the results of that experiment, when taken in conjunction with the calibrated value A of the first parameter, can suggest or indicate that the second parameter should be assigned a value B. Thus, when the first parameter is calibrated before the second parameter, the parametric state of the digital twin can be calibrated to an A-B instantiation. Now, suppose instead that the second parameter is calibrated before the first parameter. In such case, an experiment corresponding or tailored to the second parameter can be performed on the scientific instrument, and the results of that experiment can suggest or indicate that the second parameter should be assigned a value C. Next, some other experiment corresponding or tailored to the first parameter can be performed on the scientific instrument, and the results of that experiment, when taken in conjunction with the calibrated value C of the second parameter, can suggest or indicate that the first parameter should be assigned a value D. Thus, when the second parameter is calibrated before the first parameter, the parametric state of the digital twin can be calibrated to a D-C instantiation. This example shows that there can be multiple possible parametric state instantiations (e.g., the A-B instantiation and the D-C instantiation) that are consistent with the experiments performed on the scientific instrument, and this example also shows that which of these multiple possible parametric state instantiations that is ultimately chosen or selected by existing techniques can depend upon the order in which the digital twin parameters are calibrated. Having the chosen or selected instantiation of the parametric state of the digital twin turn on the order of calibration can be considered as unjustified, arbitrary, or as particularly troublesome in situations where parameter interdependencies are not known or well understood *ab initio.*

Furthermore, the present inventors realized that this inability to handle the parameter ambiguity problem can be exacerbated by the use of different test metrics for different parameters. After all, utilizing different experimental procedures, tests, or metrics for different parameters can be considered as treating different parameters inconsistently with each other (e.g., indeed, different metrics are often measurable with different uncertainties or resolution errors). The introduction of such inconsistency into the digital twin calibration process can reduce the likelihood of locating the true physical state of the scientific instrument from among multiple possible parametric state instantiations.

As the present inventors recognized, for any given digital twin, it might be possible to attempt to identify, in *ad hoc* fashion, one or more specific experimental tests, observations, or metrics that are not subject to the parameter ambiguity problem. However, such an *ad hoc* approach would be excessively costly in terms of time-consumption, effort, and blind experimentation (e.g., for some particular digital twin representing some particular type of scientific instrument, much effort might be expended to experimentally identify tests, observations, or metrics that are not subject to the parameter ambiguity problem; unfortunately, such effort and experimentation must then be repeated from scratch for some different digital twin representing some different type of scientific instrument). Furthermore, such an *ad hoc* approach might not even work, since it is not generally or universally guaranteed that any given digital twin has at least some experimental tests, observations, or metrics that are not subject to the parameter ambiguity problem. Further still, such an *ad hoc* approach would be considered more like sidestepping or avoiding the parameter ambiguity problem in the first place, rather than dealing with or solving the parameter ambiguity problem when it occurs.

Accordingly, systems or techniques that can ameliorate one or more of these technical problems can be desirable.

Various embodiments described herein can address one or more of these technical problems. One or more embodiments described herein can include systems, computer-implemented methods, apparatus, or computer program products that can facilitate improved digital twin calibration for scientific instruments. In particular, various embodiments described herein can involve calibrating the parameters of a digital twin of a scientific instrument via implementation of a state-wide Bayesian filter. More specifically, the state-wide Bayesian filter can be an algorithm or procedure that involves performing a plurality of calibration iterations on the digital twin. As described herein, each calibration iteration can involve performing a recursive Bayesian update (e.g., via Bayes' rule) on an entirety of the parametric state of the digital twin. Moreover, such recursive Bayesian update can be based on an observable that is exhibitable by the scientific instrument, simulatable by the digital twin, and common or the same across the plurality of calibration iterations. For at least this reason, that observable can be referred to as an iteration-common observable.

Note how such embodiments can differ from existing techniques. As mentioned above, existing techniques separately calibrate the parameters of the digital twin in order of dependency (e.g., update geometry parameters in a first iteration; then update stiffness and yield strength parameters in a second iteration; and finally update damping coefficient parameters in a third iteration). In stark contrast, various embodiments described herein do not involve separately or independently calibrating the parameters of the digital twin. Instead, various embodiments described herein involve incrementally updating, adjusting, or otherwise modifying the numerical values of all the parameters of the digital twin during each calibration iteration (e.g., if various embodiments described herein were implemented in the above example, the geometry parameters, the stiffness and yield strength parameters, and the damping coefficient parameters would all be incrementally updated in a first iteration; the geometry parameters, the stiffness and yield strength parameters, and the damping coefficient parameters would all be incrementally updated again in a following iteration; the geometry parameters, the stiffness and yield strength parameters, and the damping coefficient parameters would all be incrementally updated yet again in still another following iteration). Moreover, as mentioned above, existing techniques utilize different test metrics or observables in each calibration iteration (e.g., geometry parameters are directly measured in the first calibration iteration; stiffness and yield strength parameters are estimated via a load-displacement metric in the second calibration iteration; and damping coefficient parameters are estimated via a vibration or initial condition metric in the third calibration iteration). In stark contrast, various embodiments described herein do not involve utilizing such different test metrics or observables. Instead, various embodiments described herein involve utilizing a single, common, or universal test metric or observable across all calibration iterations (e.g., if various embodiments described herein were implemented in the above example, each calibration iteration would involve performing the load-displacement test, or each calibration iteration would instead involve performing the vibration or initial condition test).

In various aspects, these differences between existing techniques and various embodiments described herein can cause such embodiments to overcome various disadvantages or problems encountered by such existing techniques.

Indeed, as mentioned above, because existing techniques perform calibration in order of parameter interdependencies, such existing techniques are usable only for physically intuitive digital twin parameters that have easily-understood interdependencies (e.g., like geometric parameters, stiffness and yield strength parameters, and damping coefficient parameters). In stark contrast, various embodiments described herein do not require or necessitate any *a priori* information regarding interdependencies among the digital twin parameters. Indeed, all digital twin parameters can be incrementally updated in each calibration iteration as described herein without regard to their interdependencies, rather than different parameters being updated in different iterations in order of their dependencies. Accordingly, various embodiments described herein can be considered as generalizable to digital twin parameters having highly complex, complicated, or unknown interactions or interdependencies with each other (e.g., like optical aberration coefficients; or like the numerical elements of a quantum Hamiltonian).

Moreover, as mentioned above, because existing techniques perform calibration in order of parameter interdependencies using different test metrics or observables for different subsets of parameters, such existing techniques are unable to adequately handle the parameter ambiguity problem. Indeed, it is possible (particularly for digital twin parameters that have unknown or highly complicated interdependencies) for multiple different instantiations of the parametric state of a digital twin associated with a scientific instrument to be consistent with experimental results obtained from the scientific instrument. However, only one of those multiple different instantiations can be considered as actually matching the true physical state of the scientific instrument. By separately calibrating parameters in order of dependency and by using different test metrics or observables for different parameters, existing techniques arbitrarily lock themselves into one of those multiple different instantiations, without even realizing that such multiple different instantiations are possible. In stark contrast, various embodiments described herein do not separately calibrate parameters in order of dependency using different observables for different parameters. Instead, various embodiments described herein can incrementally adjust all of the parameters during each calibration iteration (rather than adjusting different parameters during different iterations), and such adjustment can be based on an experimental metric or observable that is common or universal throughout all of the calibration iterations (e.g., the same experiment or test can be performed on the scientific instrument in each calibration iteration, rather than performing a different experiment or test during each iteration or for different parameters). The present inventors experimentally verified that such a calibration procedure properly calibrates digital twin parameters even in the presence of the parameter ambiguity problem. In other words, existing techniques tend to inaccurately or incorrectly calibrate digital twin parameters in the presence of the parameter ambiguity problem, whereas various embodiments described herein accurately or correctly calibrate digital twin parameters in the presence of the parameter ambiguity problem.

Accordingly, various embodiments described herein can be considered as facilitating improved digital twin calibration for scientific instruments.

Various embodiments described herein can be considered as a computerized tool (e.g., any suitable combination of computer-executable hardware or computer-executable software) that can be electronically installed on or otherwise with respect to a scientific instrument and that can facilitate improved digital twin calibration for the scientific instrument. In various aspects, such computerized tool can comprise an access component, a calibration component, or a post-calibration component.

In various embodiments, the scientific instrument can be any suitable computerized device that can electronically capture, measure, or otherwise record any suitable electronic information that carries clinical or laboratory significance (e.g., can be a mass spectrometer, can be an electron microscope). In any case, the scientific instrument can comprise a set of controllable instrument settings. In various aspects, a controllable instrument setting can be any suitable configurable hardware characteristic or configurable software characteristic of the scientific instrument that can be directly controlled, adjusted, or changed in response to electronic instructions or commands received from a user or technician of the scientific instrument (e.g., can be a user-controlled voltage or current setting of the scientific instrument, a user-controlled temperature setting of the scientific instrument, or a user-controlled actuator setting of the scientific instrument).

In various embodiments, there can be a digital twin that corresponds to or is otherwise associated with the scientific instrument. In various aspects, the digital twin can be any suitable combination of any suitable mathematical models or physics-based models that can numerically, computationally, or analytically predict, forecast, or otherwise simulate how the scientific instrument, or any suitable portion thereof, will respond to any given usage scenario. More specifically, the digital twin can comprise a parametric state, a set of input variables, and a set of output variables.

In various instances, the parametric state can comprise any suitable number of parameters, each of which can be any suitable mathematical quantity that can represent any suitable characteristic, attribute, or property (whether physical or theoretical) of the scientific instrument (e.g., geometry of the scientific instrument, material properties of the scientific instrument, aberration coefficients of the scientific instrument). In various instances, the characteristics, attributes, or properties of the scientific instrument that are represented by the parametric state can be intransient (e.g., can refrain from drifting over time) or transient (e.g., can drift over time). In various cases, the characteristics, attributes, or properties of the scientific instrument that are represented by the parametric state can be indirectly affected or influenced by the set of controllable instrument settings (e.g., a damping coefficient of the scientific instrument can be indirectly changed by changing one or more controllable motor settings of the scientific instrument). Nevertheless, it can be the case that any of such characteristics, attributes, or properties can be not directly controllable by the set of controllable instrument settings (e.g., the scientific instrument does not have a button or knob that allows for direct or explicit selection of a desired damping coefficient; if it did, calibration of a damping coefficient parameter would be trivial).

In various aspects, the set of input variables can comprise any suitable number of input variables. In various instances, an input variable can be any suitable mathematical quantity that can represent any suitable detail or aspect of a usage scenario that can be encountered by the scientific instrument (e.g., can represent or quantify a mass or chemical composition of a laboratory specimen that can be scanned or analyzed by the scientific instrument).

In various cases, the set of output variables can comprise any suitable number of output variables. In various aspects, an output variable can be any suitable mathematical quantity that can represent any suitable detail or aspect of the scientific instrument that is desired to be computed, predicted, or tracked (e.g., marginal wear or degradation accumulated by the scientific instrument or any portion thereof in response to a given usage scenario).

In various aspects, the set of input variables can be collectively considered as the operand of the digital twin, the parametric state can be collectively considered as defining the operators of the digital twin, and the set of output variables can be computed or calculated by mathematically applying (e.g., via any suitable mathematical functions or compositions thereof) the parametric state to the set of input variables. Accordingly, the set of input variables can be assigned whatever numerical values define or describe any given usage scenario, and how the scientific instrument would behave or respond to that given usage scenario can be simulated, predicted, or forecasted by applying the parametric state to the set of input variables. However, such simulation, prediction, or forecast can be inaccurate if the parametric state of the digital twin does not closely match the true physical state of the scientific instrument.

Thus, it can be desired to calibrate or synchronize the parametric state of the digital twin with the true physical state of the scientific instrument. As described herein, the computerized tool can facilitate such calibration or synchronization.

In various embodiments, the access component of the computerized tool can electronically access the set of controllable instrument settings or the digital twin. That is, the access component can electronically interface or communicate with the set of controllable instrument settings or with the digital twin, such that the access component can serve as a conduit through which other components of the computerized tool can electronically interact with (e.g., send electronic commands to, read electronic signals from) the set of controllable instrument settings or with the digital twi n .

In various embodiments, the calibration component of the computerized tool can electronically synchronize the parametric state of the digital twin to the true physical state of the scientific instrument. In other words, the calibration component can identify a calibrated instantiation of the parametric state that is estimated or predicted to be an acceptable approximation of (e.g., to be within any suitable threshold margin of similarity of) the true physical state of the scientific instrument. In particular, the calibration component can accomplish this by performing or implementing a state-wide Bayesian filter on both the scientific instrument and the digital twin.

In various aspects, the state-wide Bayesian filter can comprise a plurality of calibration iterations that are performed in sequence. That is, the plurality of calibration iterations can comprise an initial calibration iteration and a final calibration iteration. In various instances, the plurality of calibration iterations can be driven by an iteration-common observable. In various cases, the iteration-common observable can be, represent, or otherwise refer to any suitable measurable or observable behavior that: can be exhibited by the scientific instrument during or after running a standardized or repeatable usage scenario; and can be simulatable (e.g., predictable, outputtable, calculable) by the digital twin. In some cases, the iteration-common observable can be any of the set of output variables that are computed in response to the standardized or repeatable usage scenario. In other cases, the iteration-common observable can instead be derived from any of the set of output variables that are computed in response to the standardized or repeatable usage scenario. In any case, each of the plurality of calibration iterations can involve: operating or running the scientific instrument according to that standardized or repeatable usage scenario, so as to measure or observe the behavior of the scientific instrument with respect to the iteration-common observable; simulating that standardized or repeatable usage scenario on the digital twin, so as to predict the scientific instrument's behavior with respect to the iteration-common observable; and incrementally updating, via recursive application of Bayes' rule, an entirety of the parametric state of the digital twin (e.g., all of the parameters of the digital twin, rather than merely a subset thereof), based on errors between the measured or observed behavior exhibited by the scientific instrument and the simulated behavior predicted by the digital twin. Note that the adjective "iteration-common" can be considered as appropriate since the iteration-common observable is used across all of the plurality of calibration iterations (e.g., that one metric or observable is common or universal to all of the calibration iterations).

More specifically, a first or initial calibration iteration of the plurality of calibration iterations can be performed as follows.

In various aspects, the true physical state of the scientific instrument can be unknown. But despite such unknown true physical state, the calibration component can cause, instruct, or otherwise command the scientific instrument to operate or run according to the standardized or repeatable usage scenario. During or after such operation or run, the calibration component can electronically measure (or can instruct the scientific instrument to electronically measure) the scientific instrument's behavior with respect to the iteration-common observable. This can be referred to as a first measured observation of the iteration-common observable.

In various instances, the calibration component can randomly sample or randomly select a first plurality of parametric state instantiations of the digital twin from an unconstrained or unrestricted version of a state-space of the digital twin. More specifically, each parameter of the digital twin can be considered as a mathematical quantity that can originate from a respective defined domain of values, all of those respective defined domains can collectively be considered as forming the state-space of the digital twin, and any suitable number of instantiations of the parametric state can be chosen at random from such state-space.

In various cases, the calibration component can cause, instruct, or otherwise command the digital twin to run or simulate the standardized or repeatable usage scenario using each of the first plurality of parametric state instantiations. In other words, for each given one of the first plurality of parametric state instantiations, the digital twin can predict how the scientific instrument would behave with respect to the iteration-common observable, assuming that the scientific instrument's true physical state matched the given parametric state instantiation. This can yield a first plurality of simulated observations of the iteration-common observable.

In various aspects, for each given one of the first plurality of parametric state instantiations, the calibration component can compute a respective weight, based on an error (e.g., mean absolute error (MAE), mean squared error (MSE), cross-entropy error) between the first measured observation of the iteration-common observable and whichever of the first plurality of simulated observations corresponds to that given parametric state instantiation. In various cases, the weight assigned to any given parametric state instantiation can be based on a reciprocal of, can be based on a complement of, or can otherwise be inversely proportional to whatever error is computed for that given parametric state instantiation.

In various instances, the calibration component can delete, remove, or otherwise discard whichever of the first plurality of parametric state instantiations that have weights below any suitable threshold weight value. This can yield a first plurality of remaining parametric state instantiations. In various cases, the calibration component can compute one or more variances of the first plurality of remaining parametric state instantiations, and the calibration component can compare those one or more variances to any suitable threshold variance value.

If those one or more variances satisfy (e.g., are below) the threshold variance value, the calibration component can compute the calibrated parametric state instantiation, based on the first plurality of remaining parametric state instantiations. In particular, the calibrated parametric state instantiation can be equal to, or otherwise based on, a weighted average of the first plurality of remaining parametric state instantiations. As mentioned above, the calibrated parametric state instantiation can be considered as being an acceptable or sufficient approximation of the true physical state of the scientific instrument. Accordingly, the calibration component can, in various instances, cause the parameters of the digital twin to take on whatever numerical values are indicated by the calibrated parametric state instantiation.

Instead, if those one or more variances fail to satisfy (e.g., are above) the threshold variance value, the calibration component can apply any suitable active settings adjustment (e.g., knob turn, button press, joystick displacement, graphical user interface invocation or clicking) to any of the set of controllable instrument settings of the scientific instrument. In various aspects, the calibration component can respectively modify each of the first plurality of remaining parametric state instantiations in accordance with that active settings adjustment, and such modification can yield a first plurality of modified remaining parametric state instantiations. Indeed, as mentioned above, the characteristics, attributes, or properties of the scientific instrument that are represented by the parameters of the digital twin cannot be directly or explicitly controlled or selected by the set of controllable instrument settings (e.g., otherwise, calibration would be trivial). However, those characteristics, attributes, or properties can nevertheless be indirectly influenced in a known or understood way or pattern by the set of controllable instrument settings. In other words, any given change to the set of controllable instrument settings can be expected to cause a commensurate, related, or otherwise known change in those characteristics, attributes, or properties of the scientific instrument (e.g., in the unknown true physical state of the scientific instrument). In still other words, changing a particular controllable instrument setting by a particular amount or percentage can be known or expected to change one or more respective ones of those characteristics, attributes, or properties by one or more respective amounts or percentages. So, for each given one of the first plurality of remaining parametric state instantiations, the calibration component can adjust, modify, or change that given remaining parametric state instantiation in whatever way that would be expected to be caused by the active settings adjustment, thereby yielding a respective one of the first plurality of modified remaining parametric state instantiations.

Now, a second calibration iteration of the plurality of calibration iterations can be performed as follows.

In various aspects, the true physical state of the scientific instrument can still be unknown, although such true physical state can have been changed in some known or expected way by the aforementioned active settings adjustment. Just as above, the calibration component can cause, instruct, or otherwise command the scientific instrument to operate or run according to the standardized or repeatable usage scenario, and the calibration component can accordingly measure (or can instruct the scientific instrument to measure) the scientific instrument's behavior with respect to the iteration-common observable. This can be referred to as a second measured observation of the iteration-common observable.

Now, in various instances, the calibration component can randomly sample or randomly select a second plurality of parametric state instantiations from the state-space of the digital twin. However, rather than sampling or selecting from the unconstrained or unrestricted version of the state-space, the calibration component can instead sample or select from an incrementally constrained or restricted version of the state-space. In various aspects, that incrementally constrained or restricted version of the state-space can be based on the first plurality of modified remaining parametric state instantiations. More specifically, the first plurality of modified remaining parametric state instantiations can be considered as Bayesian evidence which can be used in a recursive Bayesian update to tighten or shrink the state-space of the digital twin. The practical effect of such recursive Bayesian update can be to cause the second plurality of parametric state instantiations to be numerically similar to, numerically close to, or otherwise picked from whatever regions or spans of the state-space that are near or local to the first plurality of modified remaining parametric state instantiations (e.g., the second plurality of parametric state instantiations can be not sampled or selected from regions or spans of the state-space that do not contain or that are far away from the first plurality of modified remaining parametric state instantiations).

In various cases, the second calibration iteration can then proceed just as described above. That is, the calibration component can: cause the digital twin to run or simulate the standardized or repeatable usage scenario using each of the second plurality of parametric state instantiations, thereby yielding a second plurality of simulated observations of the iteration-common observable; compute a respective weight for each of the second plurality of parametric state instantiations, based on errors between the second measured observation of the iteration-common observable and the second plurality of simulated observations of the iteration-common observable; delete whichever of the second plurality of parametric state instantiations that have weights below the threshold weight value, thereby yielding a second plurality of remaining parametric state instantiations; and compare one or more variances of the second plurality of remaining parametric state instantiations to the threshold variance value. If those one or more variances satisfy (e.g., are below) the threshold variance value, the calibration component can compute the calibrated parametric state instantiation, based on the second plurality of remaining parametric state instantiations (e.g., equal to or otherwise based on a weighted average of the second plurality of remaining parametric state instantiations). If those one or more variances instead fail to satisfy (e.g., are above) the threshold variance value, the calibration component can apply any other active settings adjustment to the set of controllable instrument settings of the scientific instrument, and the calibration component can commensurately modify the second plurality of remaining parametric state instantiations based on that active settings adjustment, thereby yielding a second plurality of modified remaining parametric state instantiations. The calibration component can then proceed to a third calibration iteration of the state-wide Bayesian filter.

The state-wide Bayesian filter can proceed in this way, with each calibration iteration incrementally narrowing, tightening, or shrinking the state-space of the digital twin until the threshold variance value is satisfied. When the threshold variance value is finally satisfied in a given calibration iteration, the calibrated parametric state instantiation can be equal to the weighted average of whatever plurality of remaining parametric state instantiations was computed during that given calibration iteration.

In various embodiments, the post-calibration component of the computerized tool can facilitate, perform, or otherwise initiate any suitable electronic actions, based on the calibration or synchronization performed by the calibration component.

As a non-limiting example, the post-calibration component can, in response to the calibration or synchronization performed by the calibration component, generate any suitable electronic notification that indicates that the digital twin is now prepared to accurately simulate, forecast, or predict future behavior of the scientific instrument. In some cases, the post-calibration component can transmit the electronic notification to any suitable computing device. In other cases, the post-calibration component can visually render the electronic notification on any suitable computer screen or monitor.

As another non-limiting example, the post-calibration component can, in response to the calibration or synchronization performed by the calibration component, cause, command, or otherwise instruct the digital twin to actually simulate, forecast, or predict future behavior of the scientific instrument. For instance, a user or technician of the scientific instrument can, via an interface (e.g., keyboard, keypad, touchscreen) of the scientific instrument, identify a particular usage scenario and can request that it be predicted how the scientific instrument would respond to or behave in that particular usage scenario. In various aspects, the post-calibration component can accordingly assign to the set of input variables whatever numerical values correspond to or define that particular usage scenario (e.g., those numerical values can be provided by the user or technician via the interface), and the post-calibration component can cause, instruct, or command the digital twin to apply the calibrated parametric state instantiation to the set of input variables, thereby yielding specific numerical values for the set of output variables. In various cases, the post-calibration component can visually render any of those specific numerical values of the set of output variables on any suitable computer screen or monitor, so as to be visible to the user or technician. In this way, the digital twin can be considered as accurately or reliably simulating how the scientific instrument would behave in or during the particular usage scenario.

Various embodiments described herein can be employed to use hardware or software to solve problems that are highly technical in nature (e.g., to facilitate improved digital twin calibration for scientific instruments), that are not abstract and that cannot be performed as a set of mental acts by a human. Further, some of the processes performed can be performed by a specialized computer (e.g., digital twin configured to model the behavior of a mass spectrometer or electron microscope) for carrying out defined acts related to scientific instruments.

For example, such defined acts can include: synchronizing, by a device operatively coupled to a processor and via execution of a state-wide Bayesian filter, a parametric state of a digital twin with a physical state of a scientific instrument; and generating, by the device and in response to the synchronizing, an electronic alert indicating that the digital twin is ready to forecast behavior of the scientific instrument. In some instances, such defined acts can include: forecasting, by the device and via running the digital twin after synchronization, how the scientific instrument would respond to a proposed usage scenario. In various cases, the state-wide Bayesian filter can comprise a set of calibration iterations, each of which can comprise a Bayesian update to an entirety of the parametric state based on an iteration-common observable that is exhibitable by the scientific instrument and simulatable by the digital twin.

Such defined acts are inherently computerized. Indeed, scientific instruments, such as chromatographs, mass spectrometers, and electron microscopes, are highly-technical computerized devices comprising specific computerized hardware (e.g., temperature sensors, pressure sensors, voltage sensors, ion beam emitters, ion focusing lenses, mass analyzers, ion detectors, beam apertures, fluid valves). A scientific instrument and the operations that it performs cannot be implemented by the human mind, or by a human with pen and paper, in any reasonable or practicable way without computers. Likewise, a digital twin (as the word "digital" in its name suggests) is also an inherently computerized or virtual construct that is used to electronically forecast or simulate future behavior of scientific instruments. A digital twin simply cannot be facilitated or executed by the human mind, or by a human with pen and paper, in any reasonable or practicable way without computers. Moreover, the very act of calibrating or synchronizing the parameters of a digital twin with the true physical state of a scientific instrument is an inherently software-based and hardware-based iterative procedure that involves computing errors between simulated behavior outputted by the digital twin and actual, real-world behavior measured by or with respect to the scientific instrument. Such calibration or synchronization cannot be performed in any meaningful, reasonable, or practicable way by the human mind or by a human with pen and paper.

Moreover, various embodiments described herein can integrate into a practical application various teachings relating to improved digital twin calibration for scientific instruments. As explained above, existing techniques facilitate such calibration by separately calibrating digital twin parameters in order of dependency (e.g., first geometric parameters, then stiffness and yield strength parameters, and then finally damping coefficient parameters) and using different observables for different parameters (e.g., direct measurement for geometric parameters; load-displacement observations for stiffness and yield point parameters; vibration observations for damping coefficient parameters). Such existing techniques are applicable only to simple, physically intuitive parameters that have well-understood or clear interdependencies; such existing techniques cannot be applied to non-physically intuitive parameters that have obscure or unclear interdependencies. Additionally, such existing techniques are unable to confidently or reliably handle the parameter ambiguity problem. Indeed, there can be multiple possible parametric state instantiations that are consistent with a given experimental finding (e.g., as is often the case when dealing with complicated, non-physically intuitive parameters like aberration coefficients or quantum Hamiltonians). However, the dependency-based order of calibration and the use of different observables for different parameters cause existing techniques to identify or settle on any arbitrary one of those multiple possible parametric state instantiations. In other words, changing the order of calibration, and thus which observables are queried when, can change which of those multiple possible parametric state instantiations is identified or settled upon. For at least these reasons, existing techniques can be considered as suffering from various technical problems.

Various embodiments described herein can help to ameliorate one or more of such technical problems. In particular, various embodiments described herein can involve calibrating the parameters of a digital twin to the physical state of a scientific instrument by leveraging or implementing a state-wide Bayesian filter. As described herein, the state-wide Bayesian filter can be an algorithm or procedure that involves performing a sequence of calibration iterations on the scientific instrument and the digital twin, where each calibration iteration can involve performing a recursive Bayesian update (e.g., posterior computation based on evidence and prior) to an entire parametric state (e.g., to all of the parameters) of the digital twin, hence the adjective "state-wide". Moreover, the state-wide Bayesian filter can be driven by an iteration-common observable that is exhibitable during operation of the scientific instrument and simulatable or forecastable by the digital twin. In various cases, the iteration-common observable can be queried or tested in or across all of the sequence of calibration iterations, hence the adjective "iteration-common". As described herein, implementation of the state-wide Bayesian filter driven by the iteration-common observable can cause each calibration iteration to incrementally tighten, shrink, or narrow the available state-space of the digital twin, until one or more variances of that state-space fall below any suitable threshold. At such point, the tightened, shrunken, or narrowed state-space can be considered as indicating or identifying the true physical state of the scientific instrument. Unlike existing techniques, various embodiments described herein are generalizable to any suitable digital twin parameters, no matter how complicated, obscure, or unknown their interdependencies are. Indeed, knowledge of parameter interdependencies is not required or even used by various embodiments described herein. Also unlike existing techniques, various embodiments described herein are not distracted, thrown off, or otherwise thwarted by the parameter ambiguity problem. Indeed, the present inventors experimentally verified that a state-wide Bayesian filter driven by an iteration-common observable is able to correctly or accurately identify the true physical state of the scientific instrument, notwithstanding there being multiple possible solutions caused either by the underlying physics-based theory or by noisy measurements. Moreover, various embodiments described herein can be considered as a generalizable or universal parameter calibration technique that can be applied to any suitable digital twin representing any suitable type of scientific instrument. Contrast this with an *ad hoc* technique that would instead require significant tailored or customized experimentation for different digital twins representing different types of scientific instruments. For at least these reasons, various embodiments described herein can be considered as a concrete and tangible technical improvement in the field of digital twins. Accordingly, various embodiments described herein certainly qualify as useful and practical applications of computers.

Furthermore, various embodiments described herein can control real-world tangible devices based on the disclosed teachings. For example, various embodiments described herein can electronically activate, deactivate, or otherwise actuate real-world hardware (e.g., ion beam emitters, ion focusing lenses, carrier fluid valves/pumps) of real-world scientific instruments (e.g., mass spectrometers, electron microscopes).

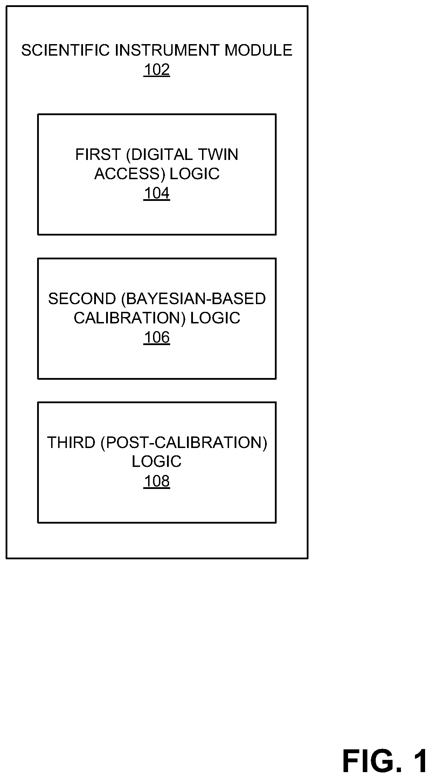

FIG. 1 illustrates an example, non-limiting block diagram of a scientific instrument module 102 in accordance with various embodiments described herein.

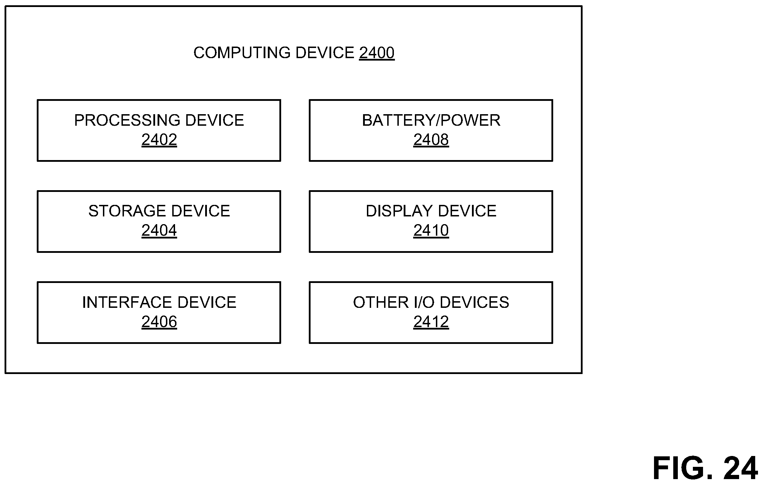

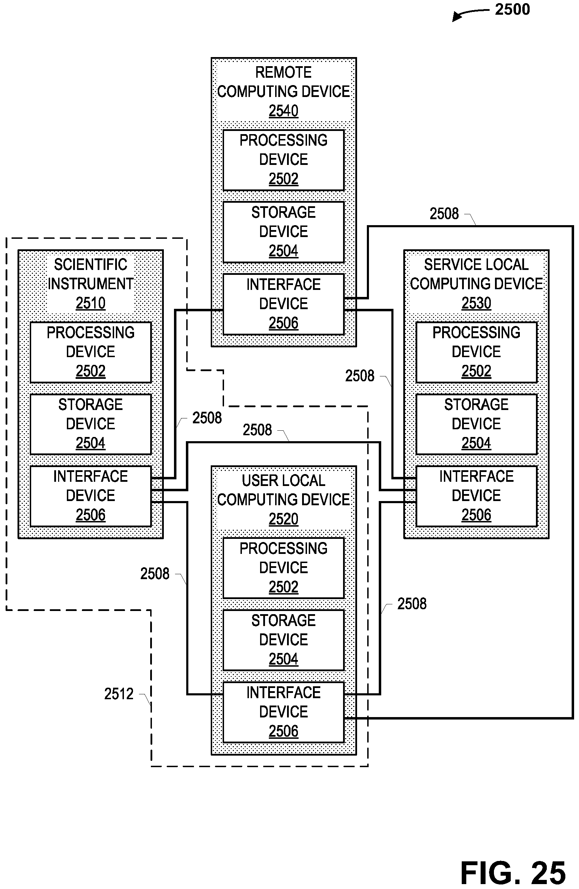

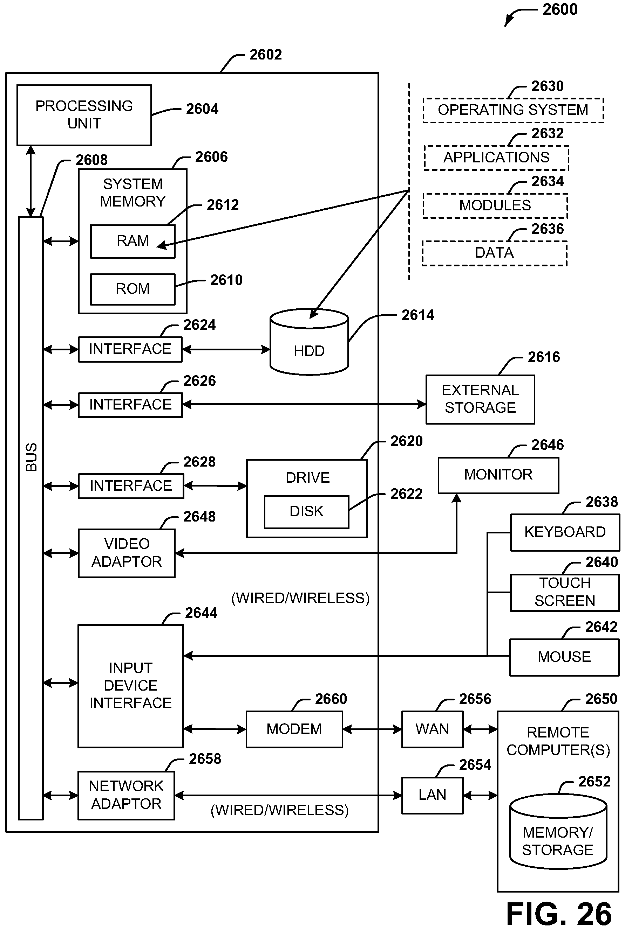

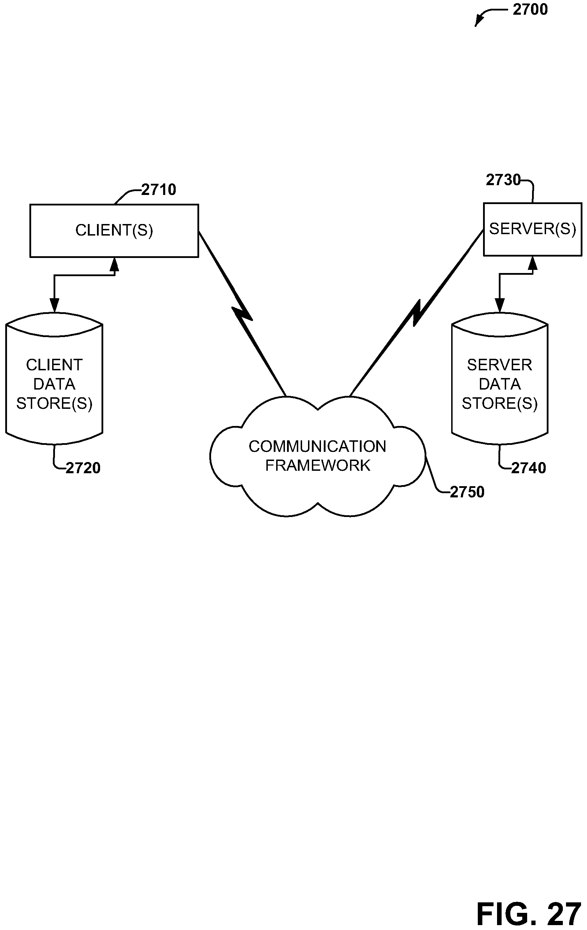

In various embodiments, the scientific instrument module 102 can be implemented by circuitry (e.g., including electrical or optical components), such as a programmed computing device. Logic of the scientific instrument module 102 can be included in a single computing device or can be distributed across multiple computing devices that are in communication with each other as appropriate. Examples of computing devices that may, singly or in combination, implement the scientific instrument module 102 are discussed herein with reference to FIGs. 24 and 26, and examples of systems or networks of interconnected computing devices, in which the scientific instrument module 102 may be implemented across one or more of the computing devices, are discussed herein with reference to FIGs. 25 and 27.

The scientific instrument module 102 can include first logic 104, second logic 106, and third logic 108. As used herein, the term "logic" can include an apparatus that is to perform a set of operations associated with the logic. For example, any of the logic elements included in the scientific instrument module 102 can be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" can refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module can omit one or more of the logic elements depicted in the associated drawings; for example, a module may include a subset of the logic elements depicted in the associated drawings when that module is to perform a subset of the operations discussed herein with reference to that module.

In various embodiments, there can be a scientific instrument corresponding to the scientific instrument module 102. In various aspects, the scientific instrument can be any suitable computerized device that can electronically measure some scientifically-relevant, clinically-relevant, or research-relevant characteristic, property, or attribute of an analytical specimen (e.g., of a known or unknown mixture, compound, or collection of matter). As a non-limiting example, a scientific instrument can be a mass spectrometer that is operatively coupled to a gas chromatograph or a liquid chromatograph. In such case, the scientific instrument can measure or determine ion spectra (e.g., relative ion abundance as a function of mass-to-charge ratio) of the analytical specimen. As another non-limiting example, a scientific instrument can be a scanning electron microscope. In such case, the scientific instrument can measure or determine a surface topography of the analytical specimen. As yet another non-limiting example, a scientific instrument can be a transmission electron microscope. In such case, the scientific instrument can measure or determine internal structural details of the analytical specimen. As a more general non-limiting example, a scientific instrument can be any suitable type of charged-particle microscope (e.g., some types of microscopes can use beams of non-electron ions to capture images).

In various embodiments, the first logic 104 can access a digital twin of the scientific instrument. In various aspects, the digital twin can be any suitable collection of mathematics-based or physics-based formulas, equations, or models that can simulate, predict, or otherwise forecast any suitable behavioral aspect of the scientific instrument. As a non-limiting example, the digital twin can comprise any suitable formulas, equations, or models that can predict an amount of wear or degradation experienced or accumulated by the scientific instrument or any portion thereof. As another non-limiting example, when given an analytical specimen, the digital twin can comprise any suitable formulas, equations, or models that can predict a scientifically-relevant, clinically-relevant, or research-relevant measurement that would be obtained by the scientific instrument if the scientific instrument were to analyze the given analytical specimen.

In various embodiments, the second logic 106 can calibrate or synchronize a parametric state of the digital twin to a physical state of the scientific instrument. After all, without such calibration or synchronization, the digital twin can be unable to accurately simulate, forecast, or predict the behavior of the scientific instrument. In various aspects, the second logic 106 can facilitate such calibration or synchronization by leveraging or implementing a state-wide Bayesian filter. In various instances, the state-wide Bayesian filter can be driven by an iteration-common observable. In various cases, the iteration-common observable can be any suitable state-dependent characteristic that is: exhibitable or observable by the scientific instrument during operation or running; and simulatable, predictable, or forecastable by the digital twin. In particular, the state-wide Bayesian filter can comprise a sequence of calibration iterations, where each calibration iteration can involve: running or operating the scientific instrument, thereby yielding a measured or observed behavior corresponding to the iteration-common observable; running or operating the digital twin, thereby yielding a simulated or forecasted behavior corresponding to the iteration-common observable; and recursively updating an entire (hence "state-wide") parametric state of the digital twin, based on errors computed between the measured or observed behavior and the simulated or forecasted behavior.

In various embodiments, the third logic 108 can facilitate any suitable electronic actions, in response to completion or performance of the second logic 106. As a non-limiting example, the third logic 108 can comprise electronically notifying (e.g., via visual rendition on an electronic display) a user or technician of the scientific instrument that the digital twin has been calibrated and is thus prepared or ready to accurately simulate, predict, or forecast the future behavior of the scientific instrument. As another non-limiting example, the third logic 108 can comprise electronically receiving user-input (e.g., via an electronic interface of the scientific instrument) that identifies or indicates a proposed usage scenario of the scientific instrument (e.g., analyzing one or more user-specified analytical specimens in a user-specified time frame using a user-specified instrument configuration), and the third logic 108 can further comprise executing or running the digital twin on that proposed usage scenario, thereby simulating, predicting, or forecasting how the scientific instrument will behave or respond to that proposed usage scenario.

Accordingly, the scientific instrument module 102 can facilitate improved digital twin calibration for scientific instruments.

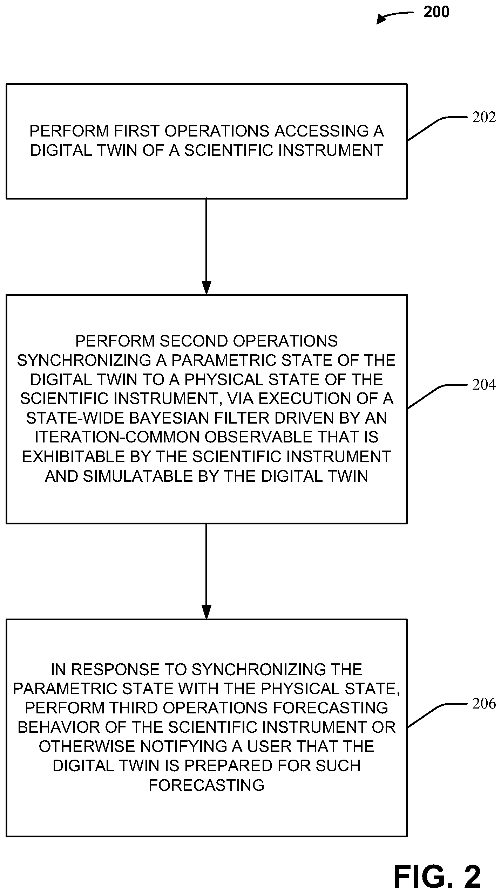

FIG. 2 is an example, non-limiting flow diagram of a computer-implemented method 200 in accordance with various embodiments described herein. The operations of the computer-implemented method 200 may be used in any suitable context to perform any suitable operations (e.g., can be performed by or used in conjunction with any of the various modules, computing devices, or graphical user interfaces described with respect to of FIGs. 1, 23, 24, 25, 26, and 27). Operations are illustrated once each and in a particular order in FIG. 2, but the operations may be reordered or repeated as desired and appropriate (e.g., different operations performed may be performed in parallel, as suitable).

In various aspects, act 202 can include performing first operations accessing a digital twin of a scientific instrument. In various cases, the first logic 104 can perform or otherwise facilitate act 202.

In various instances, act 204 can include performing second operations synchronizing a parametric state of the digital twin to a physical state of the scientific instrument, via execution of a state-wide Bayesian filter. In various aspects, the state-wide Bayesian filter can be driven by or otherwise based on an iteration-common observable that can be exhibitable by the scientific instrument and that can be simulatable by the digital twin. In various cases, the second logic 106 can perform or otherwise facilitate act 204.

In various aspects, act 206 can include performing, in response to the synchronizing the parametric state with the physical state, third operations forecasting behavior of the scientific instrument or otherwise notifying a user that the digital twin is prepared for such forecasting. In various cases, the third logic 108 can perform or otherwise facilitate act 206.

Accordingly, the computer-implemented method 200 can facilitate improved digital twin calibration for scientific instruments.

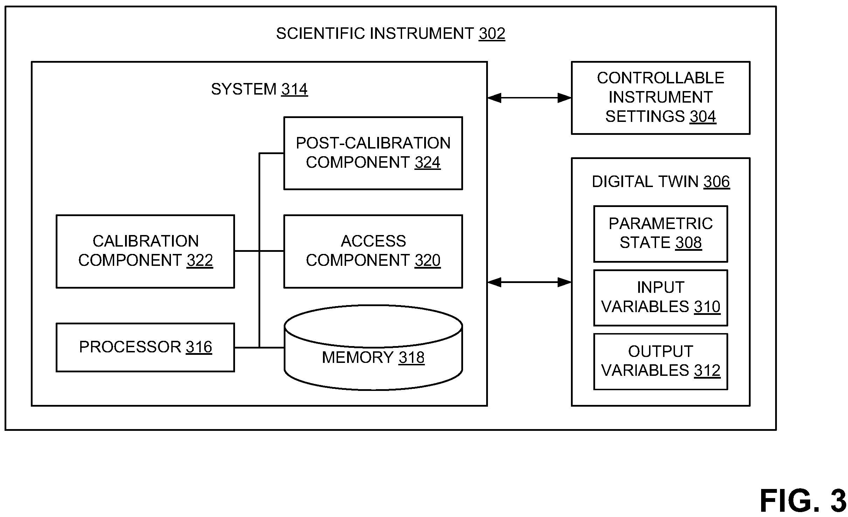

FIG. 3 illustrates a block diagram of an example, non-limiting scientific instrument 302 that can facilitate improved digital twin calibration in accordance with one or more embodiments described herein.

In various aspects, the scientific instrument 302 can be as described above. That is, the scientific instrument 302 can be any suitable computerized device that can electronically measure any suitable scientifically-relevant, clinically-relevant, or research-relevant characteristic, attribute, or property of any suitable analytical specimen. As a non-limiting example, the scientific instrument 302 can be a mass spectrometer which can be outfitted or equipped with a gas or liquid chromatograph. In such case, the scientific instrument 302 can leverage its constituent hardware (e.g., injector, oven-heated column, carrier fluid valves or pumps, ion beam emitter, ion optics lenses or shrouds, mass analyzer) to electronically determine the chemical composition or make-up of any given analytical specimen. As another non-limiting example, the scientific instrument 302 can be a scanning or transmission electron microscope. In such case, the scientific instrument 302 can leverage its constituent hardware (e.g., electron sources, anodes, condenser lenses, condenser apertures, scan coils, objective lenses, objective apertures, deflectors, condensers, stigmators, electron detectors, X-ray detectors, actuatable specimen stages) to electronically determine or map surface structures or internal structures of any given analytical specimen.

Although not explicitly shown in the figures, the scientific instrument 302 can be electronically integrated with any suitable human-computer interface device, which can be remote from or local to the scientific instrument 302. Accordingly, a user or technician associated with the scientific instrument 302 can interact with or otherwise control the scientific instrument 302. Some non-limiting examples of the human-computer interface device can be a keyboard of the scientific instrument 302, a keypad of the scientific instrument 302, a touchscreen of the scientific instrument 302, or a voice-command system of the scientific instrument 302.

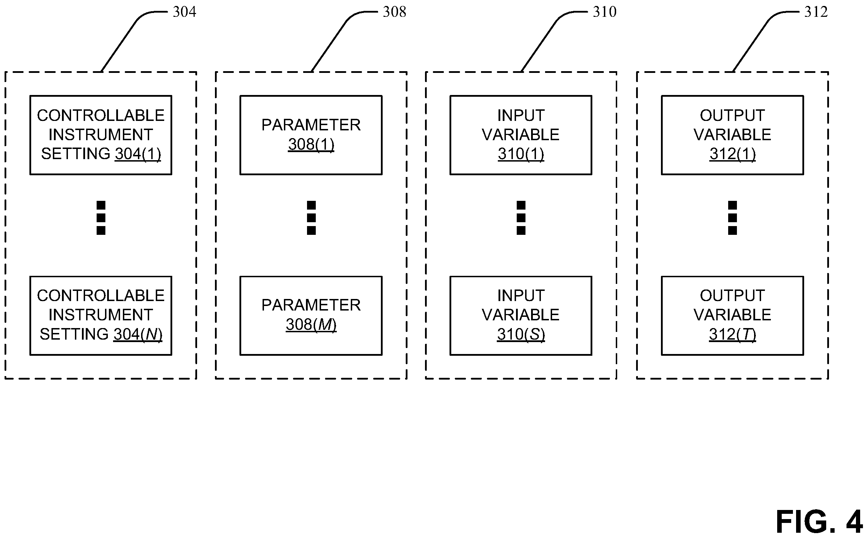

In various instances, as shown, the scientific instrument 302 can comprise a set of controllable instrument settings 304 and a digital twin 306. In various cases, the digital twin 306 can comprise a parametric state 308, a set of input variables 310, and a set of output variables 312. Various non-limiting aspects are described with respect to FIG. 4.

FIG. 4 illustrates an example, non-limiting block diagram showing the set of controllable instrument settings 304, the parametric state 308, the set of input variables 310, and the set of output variables 312 in accordance with one or more embodiments described herein.

In various aspects, the set of controllable instrument settings 304 can comprise n settings, for any suitable positive integer n: a controllable instrument setting 304(1) to a controllable instrument setting 304(n). In various instances, each of the set of controllable instrument settings 304 can be any suitable hardware-related characteristic or software-related characteristic of the scientific instrument 302 that can guide or affect how the scientific instrument 302 runs or operates with respect to any given analytical specimen and that can be selectively configured or otherwise controlled by the user or technician (e.g., via interaction with the human-computer interface device of the scientific instrument 302). That is, the controllable instrument setting 304(1) can be considered as a first user-configurable hardware-related or software-related characteristic that influences how the scientific instrument 302 runs or operates on analytical specimens, and the controllable instrument setting 304(n) can be considered as an n-th user-configurable hardware-related or software-related characteristic that influences how the scientific instrument 302 runs or operates on analytical specimens. As a non-limiting example, any of the set of controllable instrument settings 304 can be a user-configurable voltage or current setting, which can allow the user or technician to control an electrode of the scientific instrument 302, so as to selectively increase or decrease an electric voltage or electric current within, or that is applied by, the scientific instrument 302. As another non-limiting example, any of the set of controllable instrument settings 304 can be a user-configurable temperature setting, which can allow the user or technician to control a heater (e.g., oven, heating coil) or cooler (e.g., cooling fan, heat pump, refrigerator) of the scientific instrument 302, so as to selectively increase or decrease a temperature within, or that is applied by, the scientific instrument 302. As still another non-limiting example, any of the set of controllable instrument settings 304 can be a user-configurable radiation setting, which can allow the user or technician to control a radiation source (e.g., electron emitter, ion beam emitter) of the scientific instrument 302, so as to selectively increase or decrease a level of radiation within, or that is applied by, the scientific instrument 302. As even another non-limiting example, any of the set of controllable instrument settings 304 can be a user-configurable mechanical actuator setting, which can allow the user or technician to control a mechanical actuator (e.g., electric motor, specimen stage, iris aperture) of the scientific instrument 302, so as to selectively move the mechanical actuator. As yet another non-limiting example, any of the set of controllable instrument settings 304 can be a user-configurable optics setting, which can allow the user or technician to control an optical element (e.g., optical lens, an optical deflector) of the scientific instrument 302, so as to selectively change an optical quality (e.g., focal spot size or location, astigmatism, defocus) that is applied by the scientific instrument 302.

In various aspects, the digital twin 306 can be any suitable collection or set of any suitable mathematical or physics-based models that can collectively simulate, forecast, or otherwise predict any suitable behavioral detail or aspect of the scientific instrument 302. As a non-limiting example, the digital twin 306 can comprise any suitable mass continuity equations, inequalities, or formulas that pertain in some way to the scientific instrument 302. As another non-limiting example, the digital twin 306 can comprise any suitable energy balance equations, inequalities, or formulas that pertain in some way to the scientific instrument 302. As even another non-limiting example, the digital twin 306 can comprise any suitable heat transfer equations, inequalities, or formulas that pertain in some way to the scientific instrument 302. As still another non-limiting example, the digital twin 306 can comprise any suitable fluid flow equations, inequalities, or formulas that pertain in some way to the scientific instrument 302. As yet another non-limiting example, the digital twin 306 can comprise any suitable kinetic or kinematic equations, inequalities, or formulas that pertain in some way to the scientific instrument 302. As another non-limiting example, the digital twin 306 can comprise any suitable Newtonian mechanics or quantum mechanics equations, inequalities, or formulas that pertain in some way to the scientific instrument 302. As still another non-limiting example, the digital twin 306 can comprise any suitable corrosion or degradation equations, inequalities, or formulas that pertain in some way to the scientific instrument 302.

In any case, the digital twin 306 can be considered as a collection or set of mathematical or physics-based models that can simulate, forecast, or predict something about the scientific instrument 302, and those mathematical or physics-based models can be considered as being made up the parametric state 308, the set of input variables 310, and the set of output variables 312. In particular, the parametric state 308 can be considered as defining the operators or coefficients of those mathematical or physics-based models, the set of input variables 310 can be considered as the operands or arguments of those mathematical or physics-based models, and the set of output variables 312 can be considered as the simulated, predicted, or forecasted results computed by those mathematical or physics-based models.

In various aspects, the parametric state 308 of the digital twin 306 can comprise *m* parameters, for any suitable positive integer *m*: a parameter 308(1) to a parameter 308(*m*). In various cases, each parameter of the parametric state 308 can be any suitable mathematical quantity that can represent a respective physical or theoretical characteristic, attribute, or property of the scientific instrument 302. For instance, the parameter 308(1) can be a scalar, a vector, a matrix, a tensor, or any suitable combination thereof that can represent a first physical or theoretical characteristic, attribute, or property of the scientific instrument 302. Likewise, the parameter 308(*m*) can be a scalar, a vector, a matrix, a tensor, or any suitable combination thereof that can represent an *m*-th physical or theoretical characteristic, attribute, or property of the scientific instrument 302. As some non-limiting examples, any parameter of the parametric state 308 can represent: a length of the scientific instrument 302 or of any portion or component thereof; a width of the scientific instrument 302 or of any portion or component thereof; a height of the scientific instrument 302 or of any portion or component thereof; a thickness of the scientific instrument 302 or of any portion or component thereof; a radius of curvature of the scientific instrument 302 or of any portion or component thereof; a mass or density of the scientific instrument 302 or of any portion or component thereof; a stiffness of the scientific instrument 302 or of any portion or component thereof; a damping coefficient of the scientific instrument 302 or of any portion or component thereof; an electrical resistance of the scientific instrument 302 or of any portion or component thereof; an electrical impedance of the scientific instrument 302 or of any portion or component thereof; a thermal resistance of the scientific instrument 302 or of any portion or component thereof; a thermal conductivity of the scientific instrument 302 or of any portion or component thereof; a heat capacity of the scientific instrument 302 or of any portion or component thereof; an optical opaqueness of the scientific instrument 302 or of any portion or component thereof; an optical aberration coefficient (e.g., defocus coefficient, 2-fold astigmatism coefficient) of the scientific instrument 302 or of any portion or component thereof; a decoherence time of the scientific instrument 302 or of any portion or component thereof; or a quantum Hamilton element of the scientific instrument 302 or of any portion or component thereof.

In some cases, any parameter of the parametric state 308 can represent a physical or theoretical characteristic, attribute, or property that is expected to be intransient, constant, or fixed. That is, the value of such physical or theoretical characteristic, attribute, or property can be expected to not drift, decay, or otherwise change over time or with use of the scientific instrument 302. However, in other cases, any parameter of the parametric state 308 can represent a physical or theoretical characteristic, attribute, or property that is expected to be transient, unfixed, or not constant. That is, the value of such physical or theoretical characteristic, attribute, or property can be expected to slowly or quickly drift, decay, or otherwise change over time or with use of the scientific instrument 302.

Note that, in various aspects, it can be the case that any parameter of the parametric state 308 can be not directly or explicitly controlled or selected by any of the set of controllable instrument settings 304. Despite this lack of direct and explicit control, it can nevertheless be the case that any parameter of the parametric state 308 can be indirectly influenced or changed by one or more of the set of controllable instrument settings 304. As a non-limiting example, suppose that the scientific instrument 302 is an electron microscope and that the parametric state 308 includes an aberration coefficient parameter. Although an aberration coefficient can be considered as a useful theoretical property that helps to quantitatively describe optical performance or behavior of an electron microscope, no electron microscope is fabricated or manufactured with an aberration coefficient knob, slider, joystick, physical button, or software button that allows for explicit, direct selection of a specific desired aberration coefficient value. But despite this, the configurable knobs, sliders, joysticks, physical buttons, or software buttons that the electron microscope does have (e.g., defocusing knob, stigmator knob, specimen stage actuator joystick, voltage knob, temperature knob) can nevertheless indirectly influence the aberration coefficient of the electron microscope (e.g., adjusting any of the defocusing knob, stigmator knob, specimen stage actuator joystick, voltage knob, or temperature knob can cause the aberration coefficient of the electron microscope to increase or decrease).

In various aspects, the set of input variables 310 of the digital twin 306 can comprise s variables, for any suitable positive integer s: an input variable 310(1) to an input variable 310(s). In various cases, each of the set of input variables 310 can be any suitable mathematical quantity that can represent any suitable dimension, feature, detail, or aspect of a usage scenario that the scientific instrument 302 can encounter or experience. For instance, the input variable 310(1) can be a scalar, a vector, a matrix, a tensor, or any suitable combination thereof that can represent a first dimension, feature, detail, or aspect of a usage scenario that is encounterable by the scientific instrument 302. Likewise, the input variable 310(s) can be a scalar, a vector, a matrix, a tensor, or any suitable combination thereof that can represent an s-th dimension, feature, detail, or aspect of a usage scenario that is encounterable by the scientific instrument 302. As some non-limiting examples, any of the set of input variables 310 can represent: a mass or density of an analytical specimen that the scientific instrument 302 can analyze; a chemical composition of an analytical specimen that the scientific instrument 302 can analyze; a crystalline structure of an analytical specimen that the scientific instrument 302 can analyze; an absorption coefficient of an analytical specimen that the scientific instrument 302 can analyze; a warm-up time afforded or allocated to the scientific instrument 302 for analysis of an analytical specimen; a run time afforded or allocated to the scientific instrument 302 for analysis of an analytical specimen; a cool-down time afforded or allocated to the scientific instrument 302 for analysis of an analytical specimen; a maximum or minimum voltage level to be used by the scientific instrument 302 for analysis of an analytical specimen; a maximum or minimum radiation level to be used by the scientific instrument 302 for analysis of an analytical specimen; a maximum or minimum fluid flow rate to be used by the scientific instrument 302 for analysis of an analytical specimen; or a maximum or minimum temperature level to be used by the scientific instrument 302 for analysis of an analytical specimen.

In various aspects, the set of output variables 312 of the digital twin 306 can comprise *t* variables, for any suitable positive integer *t:* an output variable 312(1) to an output variable 312(t). In various cases, each of the set of output variables 312 can be any suitable mathematical quantity that can represent any suitable characteristic, attribute, property, feature, detail, or behavioral aspect of the scientific instrument 302 that is desired to be simulated, forecasted, or predicted. For instance, the output variable 312(1) can be a scalar, a vector, a matrix, a tensor, or any suitable combination thereof that can represent a first simulated, forecasted, or predicted characteristic, attribute, property, feature, detail, or behavioral aspect of the scientific instrument 302. Likewise, the output variable 312(t) can be a scalar, a vector, a matrix, a tensor, or any suitable combination thereof that can represent a *t*-th simulated, forecasted, or predicted characteristic, attribute, property, feature, detail, or behavioral aspect of the scientific instrument 302. As a non-limiting example, any of the set of output variables 312 can represent an electronic measurement that is capturable or generatable by the scientific instrument 302 in response to any given usage scenario. For instance, if the scientific instrument 302 is a mass spectrometer, then one or more output variables can represent material composition results or percentages that are outputtable by the scientific instrument 302. As another instance, if the scientific instrument 302 is an electron microscope, then one or more output variables can represent an image (e.g., a pixel array or a voxel array) that is outputtable by the scientific instrument 302. As another non-limiting example, any of the set of output variables 312 can represent a total or marginal amount of degradation or wear that the scientific instrument 302, or any portion or component thereof, can experience or accumulate in response to any given usage scenario. As yet another non-limiting example, any of the set of output variables 312 can represent a total or marginal amount of fuel, calibrant, or electricity that is consumable by the scientific instrument 302 in response to any given usage scenario. As even another non-limiting example, any of the set of output variables 312 can represent an amount of useful life (e.g., expressed in hours or runs) of the scientific instrument 302 that will remain or be left in response to any given usage scenario.

Accordingly, the digital twin 306 can simulate, forecast, or predict how the scientific instrument 302 will respond to any particular usage scenario. Specifically, the set of input variables 310 can be assigned any suitable numerical values that correspond to or otherwise define that particular usage scenario, the parametric state 308 can be applied (e.g., according to whatever mathematical functions, operations, or formulas make up the digital twin 306) to the set of input variables 310, and the set of output variables 312 can be equal to the computational results (e.g., products, differences, sums, quotients) of such application.

Referring back to FIG. 3, note that the digital twin 306 can accurately or reliably simulate, forecast, or predict the behavior of the scientific instrument 302 only if the parametric state 308 is assigned numerical values that closely match the true physical state of the scientific instrument 302. However, that true physical state can be unknown and can vary with the set of controllable instrument settings 304. Accordingly, it can be desired to calibrate or synchronize the parametric state 308 of the digital twin 306 with that unknown true physical state of the scientific instrument 302. As described herein, the scientific instrument 302 can comprise a system 314 that can facilitate such calibration or synchronization.

In various aspects, the system 314 can comprise a processor 316 (e.g., computer processing unit, microprocessor) and a non-transitory computer-readable memory 318 that is operably or operatively or communicatively connected or coupled to the processor 316. The non-transitory computer-readable memory 318 can store computer-executable instructions which, upon execution by the processor 316, can cause the processor 316 or other components of the system 314 (e.g., access component 320, calibration component 322, post-calibration component 324) to perform one or more acts. In various embodiments, the non-transitory computer-readable memory 318 can store computer-executable components (e.g., access component 320, calibration component 322, post-calibration component 324), and the processor 316 can execute the computer-executable components.

In various embodiments, the system 314 can comprise an access component 320. In various aspects, the access component 320 can electronically communicate or otherwise electronically interact with (e.g., transmit electronic instructions or commands to, receive electronic data from) the set of controllable instrument settings 304 or the digital twin 306. Accordingly, any other components of the system 314 can communicate or interact with the set of controllable instrument settings 304 or with the digital twin 306 through or via the access component 320 (e.g., the access component 320 can act as an intermediary between any other components of the system 314 and the set of controllable instrument settings 304 or the digital twin 306). However, this is a mere non-limiting example. In other cases, the access component 320 can be omitted, and any other components of the system 314 can communicate or interact directly with the set of controllable instrument settings 304 or the digital twin 306.

In various embodiments, the system 314 can comprise a calibration component 322. In various aspects, as described herein, the calibration component 322 can electronically calibrate or synchronize the parametric state 308 of the digital twin 306 with the unknown true physical state of the scientific instrument 302, by leveraging a state-wide Bayesian filter.

In various embodiments, the system 314 can comprise a post-calibration component 324. In various instances, as described herein, the post-calibration component 324 can perform or initiate any suitable electronic actions in response to the parametric state 308 of the digital twin 306 being successfully calibrated or synchronized with the unknown true physical state of the scientific instrument 302.

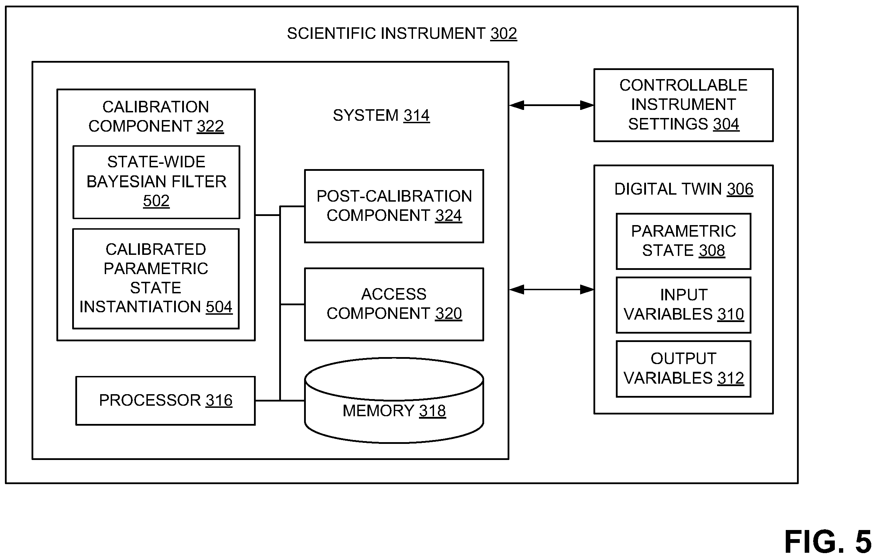

FIG. 5 illustrates a block diagram of an example, non-limiting scientific instrument including a state-wide Bayesian filter and a calibrated parametric state instantiation that can facilitate improved digital twin calibration in accordance with one or more embodiments described herein.

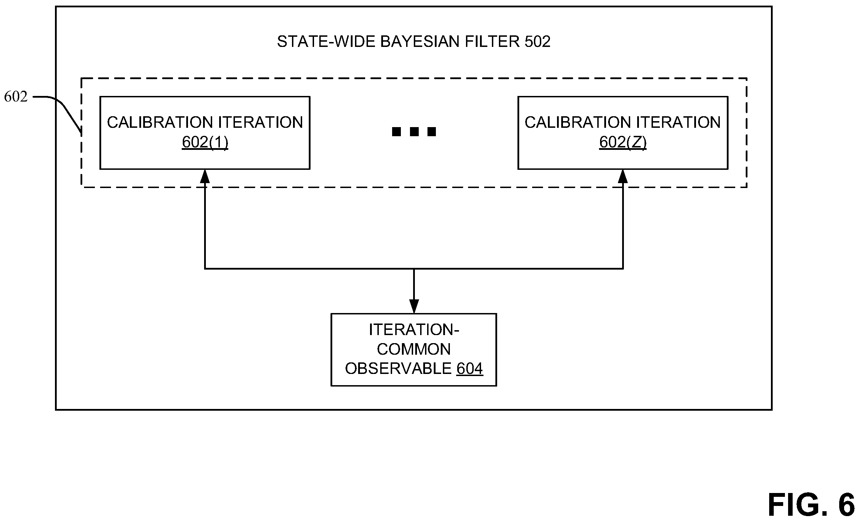

In various embodiments, the calibration component 322 can electronically identify a calibrated parametric state instantiation 504 for the digital twin 306, based on a state-wide Bayesian filter 502. In various aspects, the calibrated parametric state instantiation 504 can be considered as being or indicating whatever specific numerical values of the parameters of the parametric state 308 that are determined or inferred to be equal or otherwise close (e.g., within any suitable margin of similarity) to the unknown true physical state of the scientific instrument 302. In various instances, the state-wide Bayesian filter 502 can be an iterative procedure or algorithm that leverages actual behaviors exhibited by the scientific instrument 302, simulated behaviors predicted by the digital twin 306, and recursive Bayesian updating to ultimately identify the calibrated parametric state instantiation 504. Various non-limiting aspects are described with respect to FIGs. 6-12.

FIG. 6 illustrates an example, non-limiting block diagram showing the state-wide Bayesian filter 502 in accordance with one or more embodiments described herein.

In various embodiments, as mentioned above, the state-wide Bayesian filter 502 can be an iterative procedure or algorithm. In particular, the state-wide Bayesian filter 502 can comprise a plurality of calibration iterations 602. In various aspects, the plurality of calibration iterations 602 can comprise *z* iterations, for any suitable positive integer *z* > 1: a calibration iteration 602(1) to a calibration iteration 602(*z*). In various instances, the plurality of calibration iterations 602 can be performed in sequential order. Accordingly, the calibration iteration 602(1) can be considered as a first, initial, or beginning iteration of the plurality of calibration iterations 602, and the calibration iteration 602(*z*) can be considered as a last, final, or terminal iteration of the plurality of calibration iterations 602.

In various cases, the plurality of calibration iterations 602 can be driven by an iteration-common observable 604. In other words, the acts performed within each of the plurality of calibration iterations 602 can depend upon the iteration-common observable 604. In various aspects, the iteration-common observable 604 can correspond to or otherwise be associated with a standard, repeatable, or baseline usage scenario of the scientific instrument 302. More specifically, the iteration-common observable 604 can be any suitable measurable, trackable, recordable, or otherwise quantifiable detail, concept, aspect, or behavior that: can be exhibited or produced by the scientific instrument 302 during or after running that standard, repeatable, or baseline usage scenario; and can be simulatable, forecastable, or predictable by the digital twin 306. Accordingly, the iteration-common observable 604 can be considered as being any suitable state-dependent quantity (e.g., one or more scalars, one or more vectors, one or more matrices, one or more tensors, or any suitable combination thereof) that is equal or equivalent to any one of the set of output variables 312, or that is equal or equivalent to any suitable function of one or more of the set of output variables 312.

As a non-limiting example, suppose that the scientific instrument 302 is an electron microscope. In such case, the scientific instrument 302 can be able to measure or produce convergent beam electron diffraction (CBED) patterns by running or operating on analytical specimens, where a CBED pattern can be considered as a two-dimensional pixel array depicting an internal or external portion of an analytical specimen. In various aspects, the standard, repeatable, or baseline usage scenario can be to capture a CBED pattern of some defined analytical sample (e.g., amorphous carbon) using some defined instrument settings configuration (e.g., using defined or baseline optical, voltage, or power settings). Furthermore, when given a CBED pattern of an analytical specimen, a Fourier transform of that given CBED pattern can be calculated. So, in various instances, the iteration-common observable 604 can refer to the application of a Fourier transform to a CBED pattern produced by scanning an amorphous carbon specimen according to defined or baseline optical, voltage, or power settings.

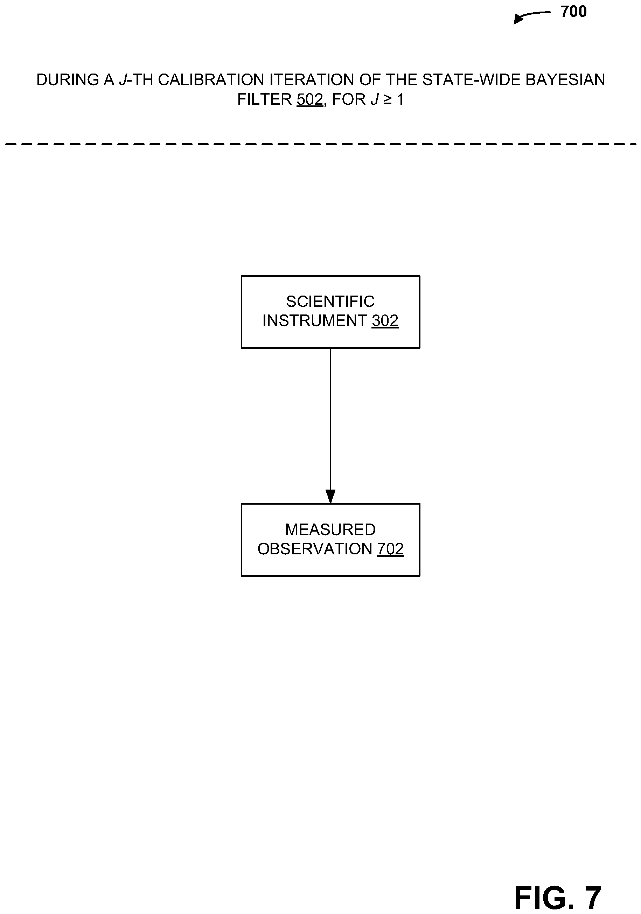

In any case, the iteration-common observable 604 can be utilized, leveraged, or otherwise referenced in each of the plurality of calibration iterations 602 (rather than using a different observable in each iteration). In particular, each of the plurality of calibration iterations 602 can involve: running the scientific instrument 302 according to the standard, repeatable, or baseline usage scenario, thereby allowing behavior of the scientific instrument 302 with respect to the iteration-common observable 604 to be measured or observed; simulating the standard, repeatable, or baseline usage scenario on the digital twin 306, thereby allowing behavior of the scientific instrument 302 with respect to the iteration-common observable 604 to be forecasted; and incrementally updating, via Bayes' theorem, an entirety of the parametric state 308 (rather than merely a subset thereof) based on errors between the measured or observed behavior and the forecasted behavior. Various non-limiting aspects are described with respect to FIGs. 7-12.

FIGs. 7-12 illustrate example, non-limiting block diagrams 700, 800, 900, 1000, 1100, and 1200 showing an iteration of the state-wide Bayesian filter 502 in accordance with one or more embodiments described herein. In particular, FIGs. 7-12 can be considered as showing how a *j*-th calibration iteration of the plurality of calibration iterations 602 can be performed or facilitated by the calibration component 322, for any suitable positive integer *j* > 1.

First, consider FIG. 7. In various aspects, the scientific instrument 302 can, at the beginning of the *j*-th calibration iteration, be considered as having some true physical state that is unknown. As mentioned above, that true physical state can be indirectly influenced by the set of controllable instrument settings 304, but that true physical state cannot be directly or explicitly selected or indicated by the set of controllable instrument settings 304 (e.g., otherwise, calibration would be trivial).

In various instances, no matter the true physical state of the scientific instrument 302, the calibration component 322 can electronically instruct, electronically command, or otherwise electronically cause the scientific instrument 302 to perform, run, or otherwise operate according to the standard, repeatable, or baseline usage scenario that corresponds to the iteration-common observable 604. Such performance, run, or operation can cause the scientific instrument 302 to exhibit some measurable behavior with respect to the iteration-common observable 604, and the calibration component 322 can electronically record, or otherwise cause the electronic recordation of, such measurable behavior. This can yield a measured observation 702. In other words, the measured observation 702 can be any suitable mathematical quantity (e.g., a scalar, a vector, a matrix, a tensor, or any suitable combination thereof) that represents how the scientific instrument 302 behaved with respect to the iteration-common observable 604 during or due to the standard, repeatable, or baseline usage scenario of the j-th calibration iteration.

As a non-limiting example, suppose, as mentioned above, that the scientific instrument 302 is an electron microscope and that the iteration-common observable 604 refers to a Fourier-transformed CBED pattern of an amorphous carbon specimen. In such case, that amorphous carbon specimen can be inserted into the scientific instrument 302 (e.g., placed on a specimen stage of the scientific instrument 302); the calibration component 322 can, during the *j*-th calibration iteration, cause the scientific instrument 302 to capture or generate a CBED pattern of the amorphous carbon specimen; the calibration component 322 can apply a Fourier transform to that captured CBED pattern; and whatever mathematical quantity that is yielded by such Fourier transform can be considered as the measured observation 702.

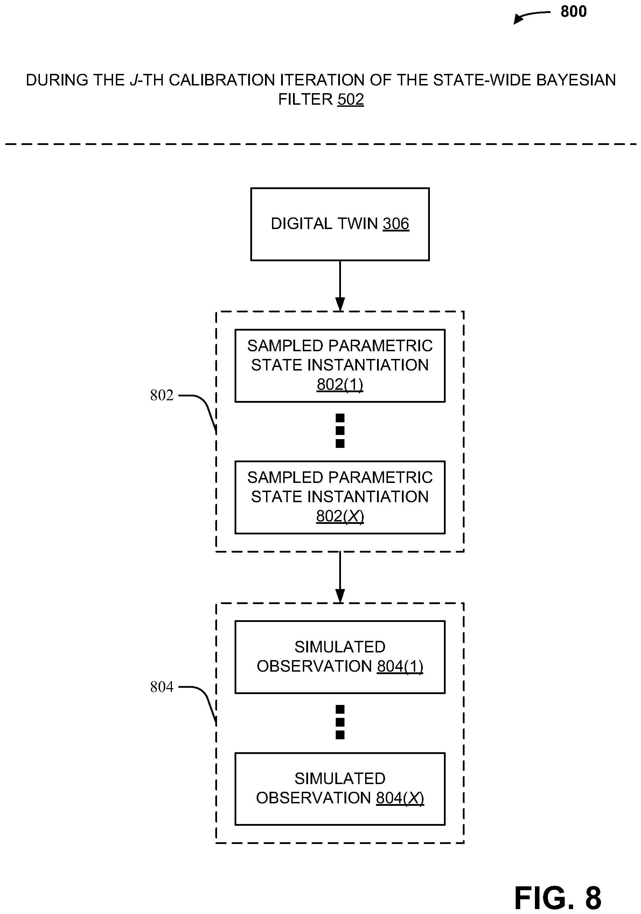

Now, consider FIG. 8. In various aspects, the parametric state 308 can be considered as having or corresponding to a state-space, anywhere from which specific instantiations of the parametric state 308 can be selected. More specifically, the parametric state 308 can comprise *m* distinct parameters; each of such *m* distinct parameters can be considered as corresponding to a respective domain; and all of such domains can, together, be collectively considered as forming or defining the state-space of the digital twin 306. As a non-limiting example, the parameter 308(1) can be considered as corresponding to a first domain, where such first domain can be considered as the set of all possible numerical values or combinations of numerical values that can be assigned to the parameter 308(1). As another non-limiting example, the parameter 308(*m*) can be considered as corresponding to an *m*-th domain, where such *m*-th domain can be considered as the set of all possible numerical values or combinations of numerical values that can be assigned to the parameter 308(*m*). In any case, all of such *m* domains can be considered as collectively making up the state-space of the digital twin 306.

In various instances, the calibration component 322 can, during the*j*-th calibration iteration, probabilistically sample the state-space of the digital twin 306. This can yield a plurality of sampled parametric state instantiations 802. In various cases, the plurality of sampled parametric state instantiations 802 can comprise *x* instantiations, for any suitable positive integer *x* > 1: a sampled parametric state instantiation 802(1) to a sampled parametric state instantiation 802(*x*). In various aspects, each of the plurality of sampled parametric state instantiations 802 can be a specific version of the parametric state 308 whose parameters are assigned specific numerical values that are probabilistically selected from their respective domains.

As a non-limiting example, the sampled parametric state instantiation 802(1) can be considered as a first specific version of the parametric state 308. So, the sampled parametric state instantiation 802(1) can comprise a first specific numerical value that is probabilistically selected from the domain of the parameter 308(1) (e.g., if the parameter 308(1) represents a damping coefficient of the scientific instrument 302 that can vary from a minimum damping value to a maximum damping value, then the sampled parametric state instantiation 802(1) can comprise a specific damping coefficient value that is probabilistically chosen from the interval formed by those minimum and maximum damping values). Likewise, the sampled parametric state instantiation 802(1) can comprise an *m*-th specific numerical value that is probabilistically selected from the domain of the parameter 308(*m*) (e.g., if the parameter 308(*m*) represents an aberration coefficient of the scientific instrument 302 that can vary from a minimum aberration value to a maximum aberration value, then the sampled parametric state instantiation 802(1) can comprise a specific aberration coefficient value that is probabilistically chosen from the interval formed by those minimum and maximum aberration values).

As another non-limiting example, the sampled parametric state instantiation 802(*x*) can be considered as an *x*-th specific version of the parametric state 308. Accordingly, the sampled parametric state instantiation 802(*x*) can comprise a first particular numerical value that is probabilistically selected from the domain of the parameter 308(1). Likewise, the sampled parametric state instantiation 802(*x*) can comprise an *m*-th particular numerical value that is probabilistically selected from the domain of the parameter 308(*m*).

In various aspects, when *j* = 1 (e.g., during the first, beginning, or initial calibration iteration), the calibration component 322 can probabilistically select the plurality of sampled parametric state instantiations 802 from an unconstrained or unrestricted version of the state-space of the digital twin 306. In contrast, when *j* > 1 (e.g., during any non-initial calibration iteration), the calibration component 322 can probabilistically select the plurality of sampled parametric state instantiations 802 from a constrained or restricted version of the state-space of the digital twin 306, where such constrained or restricted version of the state-space can be computed by performing a recursive Bayesian update on whatever version of the state-space was sampled in a (*j* - 1)-th calibration iteration (e.g., in the preceding calibration iteration).

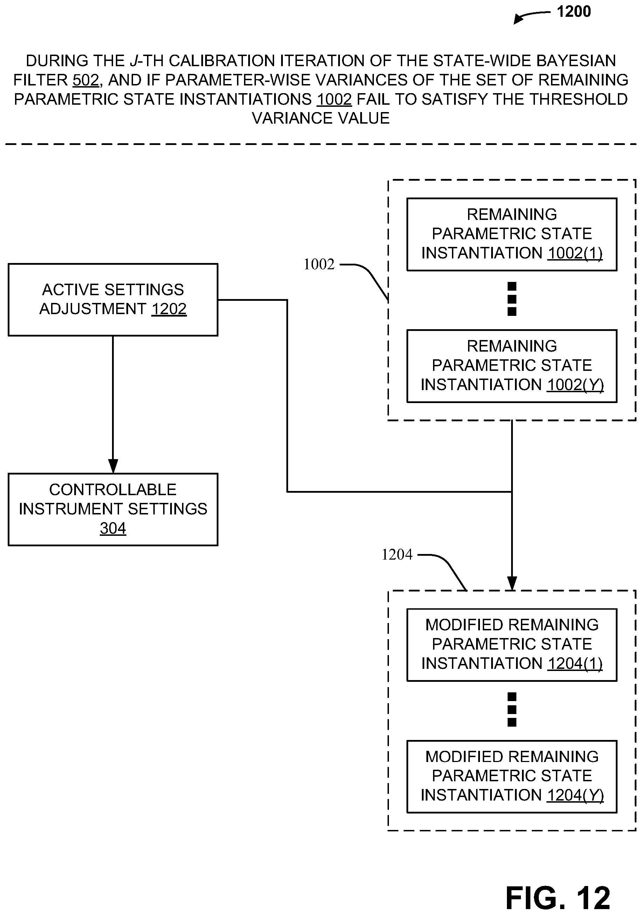

More specifically, recall that recursive Bayesian updating can involve computing (e.g., via Bayes' theorem, Bayes' rule, or Bayes' inference) a posterior distribution when given both a prior distribution and evidence. In various aspects, the calibration component 322 can select the plurality of sampled parametric state instantiations 802 from any suitable prior distribution over the state-space of the digital twin 306. If *j* = 1, then that prior distribution can be any desired or defined distribution over the state-space, such as a uniform distribution (e.g., which would cause all possible parametric state instantiations in the state-space to have an equal likelihood of being selected by the calibration component 322) or a normal or Gaussian distribution (e.g., which would cause parametric state instantiations with extreme or outlying parameter values to have lower likelihoods of being selected by the calibration component 322). However, if *j* > 1, then that prior distribution can be equal to or otherwise based on whatever posterior distribution is or was computed during the (*j* - 1)-th calibration iteration. This will be further clarified below with respect to FIG. 12.

In any case, the calibration component 322 can probabilistically select the plurality of sampled parametric state instantiations 802 from the state-space of the digital twin 306.

In various aspects, the calibration component 322 can electronically command, electronically instruct, or otherwise electronically cause the digital twin 306 to simulate a respective run of the standard, repeatable, or baseline usage scenario corresponding to the iteration-common observable 604, for each of the plurality of sampled parametric state instantiations 802. Such simulation can cause the digital twin 306 to forecast or predict what measurable or observable behavior with respect to the iteration-common observable 604 the scientific instrument 302 would exhibit, assuming that the true physical state of the scientific instrument 302 matched those indicated by each of the plurality of sampled parametric state instantiations 802. This can yield a plurality of simulated observations 804.

For instance, the calibration component 322 can run the digital twin 306 on the sampled parametric state instantiation 802(1). That is, the calibration component 322 can instruct, command, or cause the digital twin 306 to simulate, forecast, or predict how the scientific instrument 302 would behave with respect to the iteration-common observable 604 during the standard, repeatable, or baseline usage scenario, assuming that the true physical state of the scientific instrument 302 matched whatever specific numerical values are indicated by the sampled parametric state instantiation 802(1). A simulated observation 804(1) can be any suitable mathematical quantity (e.g., a scalar, a vector, a matrix, a tensor, or any suitable combination thereof) that represents such simulated, forecasted, or predicted behavior. Consider again the non-limiting example above in which the scientific instrument 302 is an electron microscope and in which the iteration-common observable 604 refers to a Fourier-transformed CBED pattern of an amorphous carbon specimen. In such case, the digital twin 306 can simulate, forecast, or predict a synthetic CBED image of that amorphous carbon specimen that the scientific instrument 302 would capture if the true physical state of the scientific instrument 302 matched the numerical values indicated by the sampled parametric state instantiation 802(1). The calibration component 322 can accordingly apply a Fourier transform to that simulated, forecasted, or predicted CBED pattern; and whatever mathematical quantity that is yielded by such Fourier transform can be considered as the simulated observation 804(1).

Similarly, the calibration component 322 can run the digital twin 306 on the sampled parametric state instantiation 802(*x*). That is, the calibration component 322 can instruct, command, or cause the digital twin 306 to simulate, forecast, or predict how the scientific instrument 302 would behave with respect to the iteration-common observable 604 during the standard, repeatable, or baseline usage scenario, assuming that the true physical state of the scientific instrument 302 matched whatever specific numerical values are indicated by the sampled parametric state instantiation 802(*x*). A simulated observation 804(*x*) can be any suitable mathematical quantity (e.g., a scalar, a vector, a matrix, a tensor, or any suitable combination thereof) that represents such simulated, forecasted, or predicted behavior. Once more, consider the non-limiting example above in which the scientific instrument 302 is an electron microscope and in which the iteration-common observable 604 refers to a Fourier-transformed CBED pattern of an amorphous carbon specimen. In such case, the digital twin 306 can simulate, forecast, or predict a synthetic CBED image of that amorphous carbon specimen that the scientific instrument 302 would capture if the true physical state of the scientific instrument 302 matched the numerical values indicated by the sampled parametric state instantiation 802(*x*). The calibration component 322 can accordingly apply a Fourier transform to that simulated, forecasted, or predicted CBED pattern; and whatever mathematical quantity that is yielded by such Fourier transform can be considered as the simulated observation 804(*x*).

In various cases, the simulated observation 804(1) to the simulated observation 804(*x*) can collectively be considered as forming the plurality of simulated observations 804.

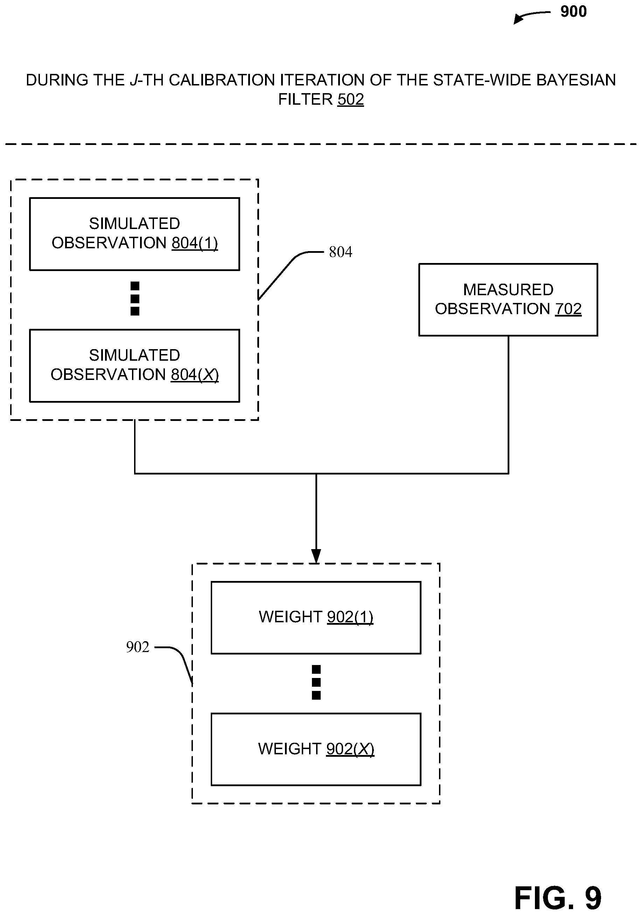

Now, consider FIG. 9. In various aspects, the calibration component 322 can electronically compute or calculate a plurality of weights 902, based on the measured observation 702 and the plurality of simulated observations 804(1). More specifically, the calibration component 322 can compute respective errors between the measured observation 702 and each of the plurality of simulated observations 804, and the plurality of weights 902 can be any suitable function of those respective errors.

As a non-limiting example, the calibration component 322 can compute any suitable error (e.g., MAE, MSE, cross-entropy error, Euclidean distance error) between the measured observation 702 and the simulated observation 804(1). In various aspects, the calibration component 322 can then compute a weight 902(1) based on that error. In various instances, the weight 902(1) can be any suitable scalar whose magnitude can range from any suitable minimum value (e.g., 0) to any suitable maximum value (e.g., 1). In various aspects, the weight 902(1) can be any suitable function of the error between the measured observation 702 and the simulated observation 804(1), such that the magnitude of the weight 902(1) is inversely proportional to the magnitude of that error (e.g., the magnitude of the weight 902(1) can increase as the error between the measured observation 702 and the simulated observation 804(1) decreases; the magnitude of the weight 902(1) can decrease as the error between the measured observation 702 and the simulated observation 804(1) increases). For instance, in some cases, the weight 902(1) can be equal to or otherwise based on a reciprocal of the error between the measured observation 702 and the simulated observation 804(1). In other cases, the weight 902(1) can be equal to or otherwise based on a complement of the error between the measured observation 702 and the simulated observation 804(1). In any case, because the weight 902(1) can be computed based on the simulated observation 804(1), and because the simulated observation 804(1) can be obtained based on the sampled parametric state instantiation 802(1), the weight 902(1) can be considered as indicating how likely it is that the sampled parametric state instantiation 802(1) matches the true physical state of the scientific instrument 302.

As another non-limiting example, the calibration component 322 can compute any suitable error (e.g., MAE, MSE, cross-entropy error, Euclidean distance error) between the measured observation 702 and the simulated observation 804(*x*). In various aspects, the calibration component 322 can then compute a weight 902(*x*) based on that error. Just as above, the weight 902(*x*) can be any suitable scalar whose magnitude can range from any suitable minimum value (e.g., 0) to any suitable maximum value (e.g., 1). Also as above, the weight 902(*x*) can be any suitable function of the error between the measured observation 702 and the simulated observation 804(*x*), such that the magnitude of the weight 902(*x*) is inversely proportional to the magnitude of that error (e.g., the weight 902(*x*) can be equal to or otherwise based on a reciprocal or complement of the error between the measured observation 702 and the simulated observation 804(*x*)). In any case, because the weight 902(*x*) can be computed based on the simulated observation 804(*x*), and because the simulated observation 804(*x*) can be obtained based on the sampled parametric state instantiation 802(*x*), the weight 902(*x*) can be considered as indicating how likely it is that the sampled parametric state instantiation 802(*x*) matches the true physical state of the scientific instrument 302.

In various cases, the weight 902(1) to the weight 902(*x*) can be considered as collectively forming the plurality of weights 902, and the plurality of weights 902 can be considered as respectively corresponding to the plurality of sampled parametric state instantiations 802.

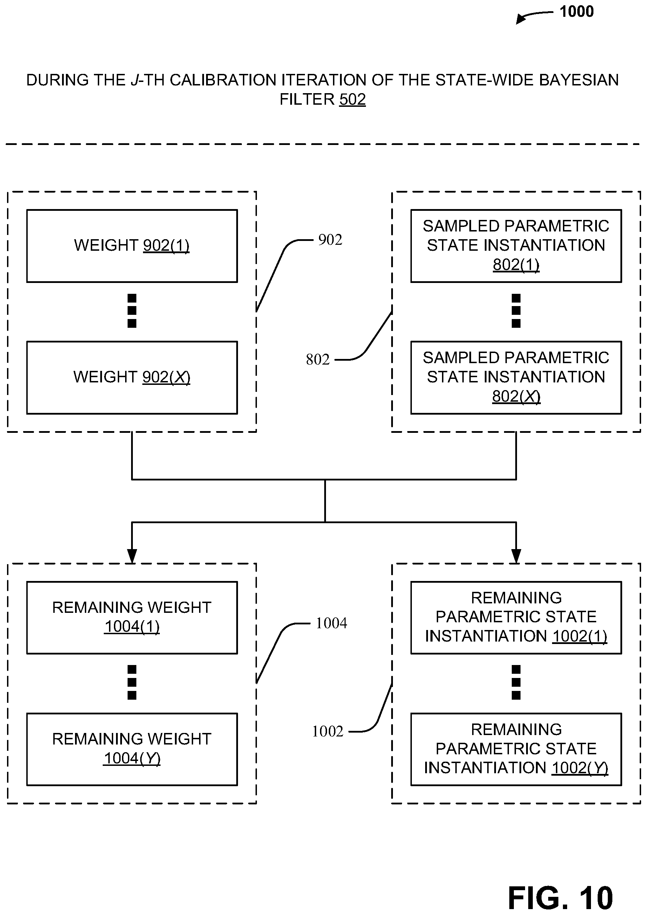

Now, consider FIG. 10. In various aspects, the calibration component 322 can electronically delete, electronically discard, or otherwise electronically ignore whichever of the plurality of sampled parametric state instantiations 802 that have a weight that fails to satisfy (e.g., that is below) any suitable threshold weight value. In other words, the calibration component 322 can eliminate whichever of the plurality of sampled parametric state instantiations 802 that are insufficiently weighty. In various instances, this can yield a plurality of remaining parametric state instantiations 1002 and a plurality of remaining weights 1004.

In various cases, the plurality of remaining parametric state instantiations 1002 can comprise *y* instantiations, for any suitable positive integer *y < x:* a remaining parametric state instantiation 1002(1) to a remaining parametric state instantiation 1002(*y*). In various aspects, the plurality of remaining weights 1004 can respectively correspond to the plurality of remaining parametric state instantiations 1002. Accordingly, since the plurality of remaining parametric state instantiations 1002 can comprise *y* instantiations, the plurality of remaining weights 1004 can likewise comprise *y* weights: a remaining weight 1004(1) to a remaining weight 1 004(*y*). As a non-limiting example, the remaining parametric state instantiation 1002(1) can be any distinct one of the plurality of sampled parametric state instantiations 802 whose weight is above the threshold weight value, and the remaining weight 1004(1) can be that weight (e.g., the weight of the remaining parametric state instantiation 1002(1)). As another non-limiting example, the remaining parametric state instantiation 1002(*y*) can be any distinct one of the plurality of sampled parametric state instantiations 802 whose weight is above the threshold weight value, and the remaining weight 1004(*y*) can be that weight (e.g., the weight of the remaining parametric state instantiation 1002(*y*)).

Now, in various aspects, the calibration component 322 can electronically compute or calculate parameter-wise variances based on the plurality of remaining parametric state instantiations 1002. Indeed, as described above, each of the plurality of remaining parametric state instantiations 1002 can comprise *m* specific numerical values respectively corresponding to the *m* parameters of the parametric state 308. So, for each given parameter of the parametric state 308, the calibration component 322 can calculate a variance of the specific numerical values that are assigned to that given parameter across the plurality of remaining parametric state instantiations 1002, thereby yielding *m* variances. Such *m* variances can collectively be considered as the parameter-wise variances of the plurality of remaining parametric state instantiations 1002.

As a non-limiting example, each of the plurality of remaining parametric state instantiations 1002 can comprise a specific numerical value that is assigned to the parameter 308(1). Thus, the plurality of remaining parametric state instantiations 1002 can be considered as collectively having a total of *y* specific numerical values that are assigned to the parameter 308(1). In various cases, the calibration component 322 can compute a variance of those *y* specific numerical values. Such variance can be considered as a first parameter-wise variance of the plurality of remaining parametric state instantiations 1002.

As another non-limiting example, each of the plurality of remaining parametric state instantiations 1002 can comprise a specific numerical value that is assigned to the parameter 308(*m*). So, the plurality of remaining parametric state instantiations 1002 can be considered as collectively having a total of *y* specific numerical values that are assigned to the parameter 308(*m*). In various cases, the calibration component 322 can compute a variance of those *y* specific numerical values. Such variance can be considered as an *m*-th parameter-wise variance of the plurality of remaining parametric state instantiations 1002.

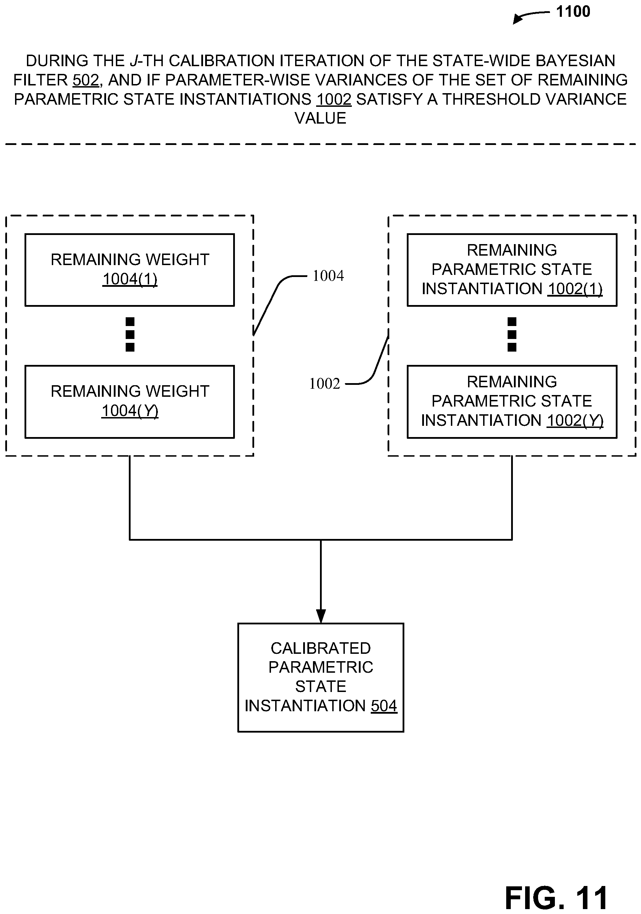

In any case, the calibration component 322 can compute parameter-wise variances across the plurality of remaining parametric state instantiations 1002. In various aspects, the calibration component 322 can compare each of those parameter-wise variances to any suitable threshold variance value. FIG. 11 illustrates how the *j*-th calibration iteration can proceed, if each of those parameter-wise variances satisfies (e.g., is below) the threshold variance value. In contrast, FIG. 12 illustrates how the *j*-th calibration iteration can proceed, if at least one of those parameter-wise variances fails to satisfy (e.g., is above) the threshold variance value.

Consider FIG. 11. If each of the parameter-wise variances satisfies the threshold variance value, the calibration component 322 can electronically compute or calculate the calibrated parametric state instantiation 504, based on the plurality of remaining parametric state instantiations 1002. In particular, the calibrated parametric state instantiation 504 can be equal to or otherwise based on a weighted average of the plurality of remaining parametric state instantiations 1002. That is, each of the plurality of remaining parametric state instantiations 1002 can be multiplied by its respective one of the plurality of remaining weights 1004 (e.g., the remaining parametric state instantiation 1002(1) can be multiplied by the remaining weight 1004(1); the remaining parametric state instantiation 1002(y) can be multiplied by the remaining weight 1004(*y*)), thereby yielding y products, and the calibrated parametric state instantiation 504 can be equal to the arithmetic average of such y products.

In other words, when the parameter-wise variances satisfy the threshold variance value, the plurality of remaining parametric state instantiations 1002 can be considered as being tightly grouped or clustered around the unknown true physical state of the scientific instrument 302, and that unknown true physical state can accordingly be estimated by weighted averaging.

Now, consider FIG. 12. If at least one of the parameter-wise variances fails to satisfy the threshold variance value, the calibration component 322 can, in various aspects, electronically perform (or otherwise cause to be electronically performed) an active settings adjustment 1202 on the scientific instrument 302. In various instances, the active settings adjustment 1202 can be any suitable change or modification (e.g., any suitable button press or button selection, any suitable knob turn by any suitable degree, any suitable slider shift by any suitable amount, any suitable joystick displacement in any suitable direction by any suitable amount) to one or more of the set of controllable instrument settings 304. Accordingly, the active settings adjustment 1202 can be considered as altering one or more user-configurable aspects (e.g., voltage, current, temperature, stage height, focal spot size, flow rate, radiation level) of the scientific instrument 302 by one or more known extents.

Indeed, although the true physical state of the scientific instrument 302 can still be unknown at this point, the active settings adjustment 1202 can be considered as altering the true physical state of the scientific instrument in some known way, by some known amount, or otherwise in some known direction. Note that, in a subsequent calibration iteration (e.g., a (*j* + 1)-th calibration iteration), the calibration component 322 can cause or instruct the scientific instrument 302 to run or perform the standard, repeatable, or baseline usage scenario in or using this newly-altered-but-still-unknown true physical state.

Referring back to the *j*-th calibration iteration, the calibration component 322 can, in various cases, electronically modify or adjust each of the plurality of remaining parametric state instantiations 1002, in accordance with or otherwise based on the active settings adjustment 1202. After all, as explained above, the true physical state of the scientific instrument 302 (e.g., whatever characteristics, attributes, or properties of the scientific instrument 302 that are represented by the parametric state 308) cannot be directly or explicitly controlled or selected by the set of controllable instrument settings 304 (again, calibration would be trivial otherwise). However, the true physical state can nevertheless be indirectly influenced in a known fashion or via a known relationship by the set of controllable instrument settings 304. For instance, suppose that the active settings adjustment 1202 shifts one or more of the set of controllable instrument settings 304 by one or more particular amounts or percentages or in one or more respective directions. In various cases, such shifts can be known or expected to commensurately shift one or more respective characteristics, attributes, or properties that make up the true physical state of the scientific instrument 302 by one or more respective amounts or percentages or in one or more respective directions. Accordingly, the calibration component 322 can electronically adjust, modify, change, or otherwise shift the plurality of remaining parametric state instantiations 1002 in accordance or compliance with the active settings adjustment 1202, thereby yielding a plurality of modified remaining parametric state instantiations 1204.

As a non-limiting example, the calibration component 322 can electronically adjust, modify, or change the numerical values of the remaining parametric state instantiation 1002(1) in whatever way, by whatever amounts or percentages, or in whatever directions that would be expected to be caused by the active settings adjustment 1202. This can yield a modified remaining parametric state instantiation 1204(1). In other words, the modified remaining parametric state instantiation 1204(1) can be considered as indicating whatever specific numerical values of the parametric state 308 that the scientific instrument 302 would be expected to have after performance of the active settings adjustment 1202, assuming that the true physical state of the scientific instrument 302 prior to the active settings adjustment 1202 matched that indicated by the remaining parametric state instantiation 1002(1).

As another non-limiting example, the calibration component 322 can electronically adjust, modify, or change the numerical values of the remaining parametric state instantiation 1002(y) in whatever way, by whatever amounts or percentages, or in whatever directions that would be expected to be caused by the active settings adjustment 1202. This can yield a modified remaining parametric state instantiation 1204(*y*). That is, the modified remaining parametric state instantiation 1204(*y*) can be considered as indicating whatever specific numerical values of the parametric state 308 that the scientific instrument 302 would be expected to have after performance of the active settings adjustment 1202, assuming that the true physical state of the scientific instrument 302 prior to the active settings adjustment 1202 matched that indicated by the remaining parametric state instantiation 1002(y).

It should be appreciated that, in some embodiments, the scientific instrument 302 can undergo a passive temporal evolution in addition to the active settings adjustment 1202 (e.g., an internal temperature of the scientific instrument 302 can naturally or passively cool down or warm up over time). Just as above, that passive temporal evolution can be considered as changing the true physical state of the scientific instrument 302 in some known way, by some known amount or percentage, or in some known direction. In such embodiments, the calibration component 322 can take that passive temporal evolution into account so as to generate the plurality of modified remaining parametric state instantiations 1204. Note that, in some cases, passive temporal evolutions of the scientific instrument 302 might be unobserved, unmeasured, or otherwise unknown. Even in such cases, the state-wide Bayesian filter 502 can, when implemented as described herein, be considered as catching up to such unobserved passive temporal evolutions.

In any case, the plurality of modified remaining parametric state instantiations 1204 can be considered or treated as Bayesian evidence that can be leveraged to incrementally constrain or restrict the state-space of the digital twin 306 during a (*j* + 1)-th calibration iteration (e.g., during the following or subsequent calibration iteration).

In particular, and as mentioned above, the calibration component 322 can, during the *j*-th calibration iteration, select the plurality of sampled parametric state instantiations 802 according to a prior distribution over the state-space. In various aspects, the calibration component 322 can, during the *j*-th calibration iteration, perform a recursive Bayesian update (e.g., via Bayes' theorem) on that prior distribution, by leveraging the plurality of modified remaining parametric state instantiations 1204 as Bayesian evidence. This can yield a posterior distribution over the state-space, where such posterior distribution is narrower or tighter (hence the terms "constrained" or "restricted") than the prior distribution. Indeed, the posterior distribution can be shaped according to the plurality of modified remaining parametric state instantiations 1204. In various aspects, the posterior distribution computed during the *j*-th calibration iteration can be treated as the prior distribution during the (*j* + 1)-th calibration iteration. Conversely, if *j* > 1, the prior distribution sampled during the j-th calibration iteration can be whatever posterior distribution was computed during the (*j* - 1)-th calibration iteration. If *j* = 1, then the prior distribution sampled during the *j*-th calibration iteration can be any suitable initial prior distribution over the state-space as desired (e.g., a uniform distribution, or a Gaussian distribution).

Accordingly, the calibration component 322 can perform each of the plurality of calibration iterations 602 as described with respect to FIGs. 7-12. Eventually, there can be some calibration iteration during which the parameter-wise variances will all satisfy the threshold variance value. Such calibration iteration can be considered as the final, terminal, or last one of the plurality of calibration iterations 602 (e.g., can be considered as the calibration iteration 602(*z*)). During such iteration, the calibrated parametric state instantiation 504 can be computed and can be considered as indicating, estimating, or approximating the specific numerical values of the true physical state of the scientific instrument 302. In various aspects, the calibration component 322 can electronically instruct, command, or otherwise cause the parametric state 308 of the digital twin 306 to be assigned whatever specific numerical values are indicated by the calibrated parametric state instantiation 504.

Note that the organization or structure of the state-wide Bayesian filter 502, as described with respect to FIGs. 6-12, can be considered as a type of particle filter technique. However, this is a mere non-limiting example for ease of explanation and illustration. In various other cases, the state-wide Bayesian filter 502 can exhibit any other suitable organization or structure, such as a Kalman filter technique.

In various embodiments, the post-calibration component 324 can facilitate any suitable electronic actions, in response to the parametric state 308 of the digital twin 306 being assigned the specific numerical values indicated by the calibrated parametric state instantiation 504.

As a non-limiting example, the post-calibration component 324 can electronically generate any suitable electronic notification or alert that indicates that the digital twin 306 has been successfully calibrated or synchronized with the scientific instrument 302. In other words, that electronic notification or alert can be considered as conveying that the digital twin 306 is ready or prepared to accurately, correctly, or reliably simulate, forecast, or predict future performance or behavior of the scientific instrument 302. In some instances, the post-calibration component 324 can electronically transmit that electronic notification or alert to any suitable computing device. In other instances, the post-calibration component 324 can electronically render that electronic notification or alert on any suitable electronic display (e.g., computer screen, computer monitor, heads-up display, hologram display).

As another non-limiting example, the post-calibration component 324 can electronically instruct, command, or otherwise cause the digital twin 306 to simulate, forecast, or predict performance or behavior of the scientific instrument 302, based on any suitable usage scenario that is indicated, identified, or selected by a user or technician of the scientific instrument 302. For instance, the user or technician can use the human-computer interface device of the scientific instrument 302 to numerically define a proposed or desired usage scenario. In response to receiving such numerical definition, the post-calibration component 324 can cause the digital twin 306 to run that proposed or desired usage scenario, using the calibrated parametric state instantiation 504. This can cause the digital twin 306 to accurately simulate, forecast, or predict how the scientific instrument 302 would actually behave or perform if it were operated according to the proposed or desired usage scenario.

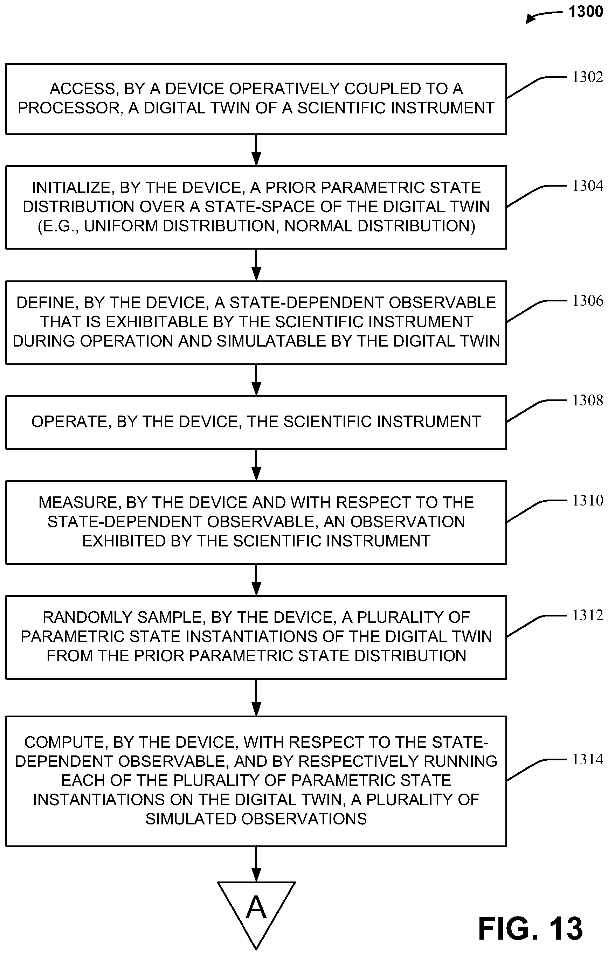

FIGs. 13-15 illustrate flow diagrams of example, non-limiting computer-implemented methods 1300, 1400, and 1500 that can facilitate improved digital twin calibration in accordance with one or more embodiments described herein. In various cases, the system 314 can facilitate the computer-implemented methods 1300, 1400, and 1500.

First, consider FIG. 13. In various embodiments, act 1302 can include accessing, by a device (e.g., via 320) operatively coupled to a processor, a digital twin (e.g., 306) of a scientific instrument (e.g., 302).

In various aspects, act 1304 can include initializing, by the device (e.g., via 322), a prior parametric state distribution over a state-space of the digital twin. In some cases, the prior parametric state distribution can be initialized as a uniform distribution or a normal/Gaussian distribution over the state-space.

In various instances, act 1306 can include defining, by the device (e.g., via 322), a state-dependent observable (e.g., 604) that is exhibitable by the scientific instrument during operation and that is simulatable by the digital twin. In some cases, the state-dependent observable can be associated with a standard, repeatable, or baseline run, usage scenario, or specimen of the scientific instrument.

In various aspects, act 1308 can include operating, by the device (e.g., via 322), the scientific instrument.

In various instances, act 1310 can include measuring, by the device (e.g., via 322) and with respect to the state-dependent observable, an observation (e.g., 702) exhibited by the scientific instrument during its operation.

In various cases, act 1312 can include randomly sampling, by the device (e.g., via 322), a plurality of parametric state instantiations (e.g., 802) of the digital twin from the prior parametric state distribution.

In various aspects, act 1314 can include computing, by the device (e.g., via 322), with respect to the state-dependent observable, and by respectively running each of the plurality of parametric state instantiations on the digital twin, a plurality of simulated observations (e.g., 804). In various cases, the computer-implemented method 1300 can proceed to act 1402 of the computer-implemented method 1400.

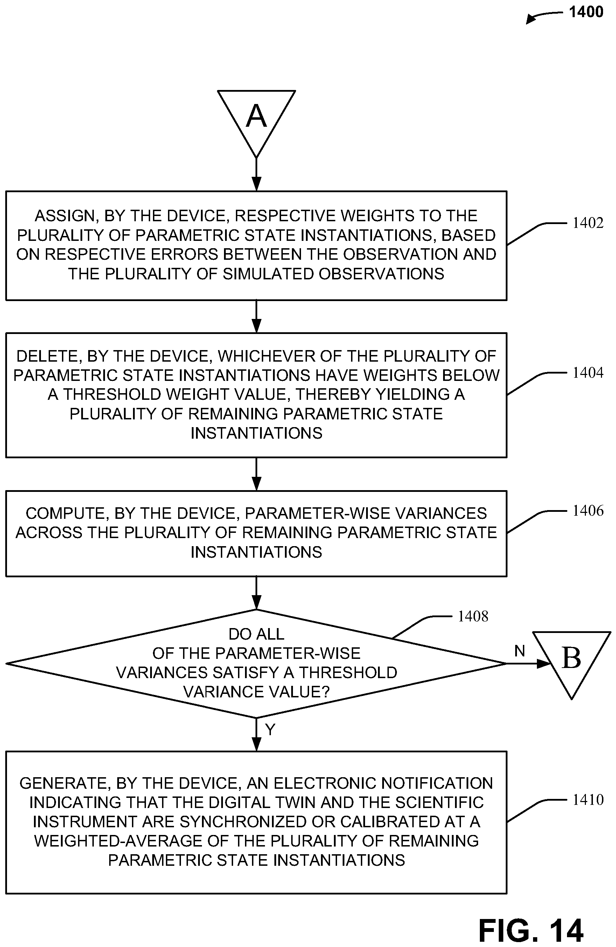

Now, consider FIG. 14. In various embodiments, act 1402 can include assigning, by the device (e.g., via 322), respective weights (e.g., 902) to the plurality of parametric state instantiations, based on respective errors between the observation and the plurality of simulated observations.

In various aspects, act 1404 can include deleting, by the device (e.g., via 322), whichever of the plurality of parametric state instantiations have weights below a threshold weight value. This can yield a plurality of remaining parametric state instantiations (e.g., 1002).

In various instances, act 1406 can include computing, by the device (e.g., via 322), parameter-wise variances across the plurality of remaining parametric state instantiations.

In various cases, act 1408 can include determining, by the device (e.g., via 322), whether all of the parameter-wise variances satisfy (e.g., are below) a threshold variance value. If so, the computer-implemented method 1400 can proceed to act 1410. If not, the computer-implemented method 1400 can proceed to act 1502 of the computer-implemented method 1500.

In various aspects, act 1410 can include generating, by the device (e.g., via 324), an electronic notification indicating that the digital twin and the scientific instrument are synchronized or calibrated at a weighted average (e.g., 504) of the plurality of remaining parametric state instantiations.

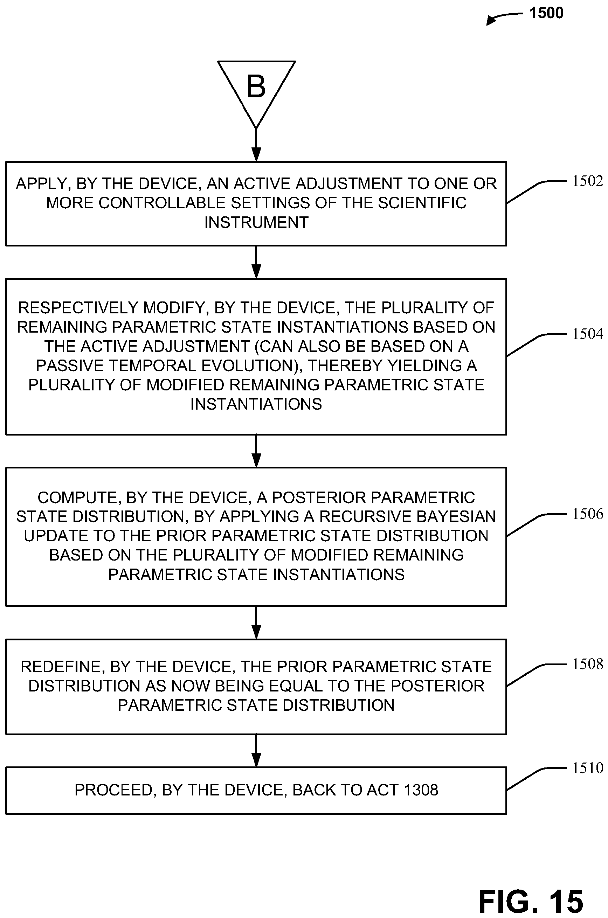

Now, consider FIG. 15. In various embodiments, act 1502 can include applying, by the device (e.g., via 322), an active adjustment (e.g., 1202) to one or more controllable settings (e.g., 304) of the scientific instrument.

In various aspects, act 1504 can include respectively modifying, by the device (e.g., via 322), the plurality of remaining parametric state instantiations based on the active adjustment. In some cases, such modification can further be based on a passive temporal evolution of the scientific instrument. In any case, such modification can yield a plurality of modified remaining parametric state instantiations (e.g., 1204).

In various instances, act 1506 can include computing, by the device (e.g., via 322), a posterior parametric state distribution, by applying a recursive Bayesian update to the prior parametric state distribution based on the plurality of modified remaining parametric state instantiations (e.g., the plurality of modified remaining parametric state instantiations can be considered as providing Bayesian evidence in an application of Bayes' theorem).

In various cases, act 1508 can include redefining, by the device (e.g., via 322), the prior parametric state distribution as now being equal to the posterior parametric state distribution.

In various aspects, act 1510 can include proceeding, by the device (e.g., via 322) back to act 1308 of the computer-implemented method 1300.

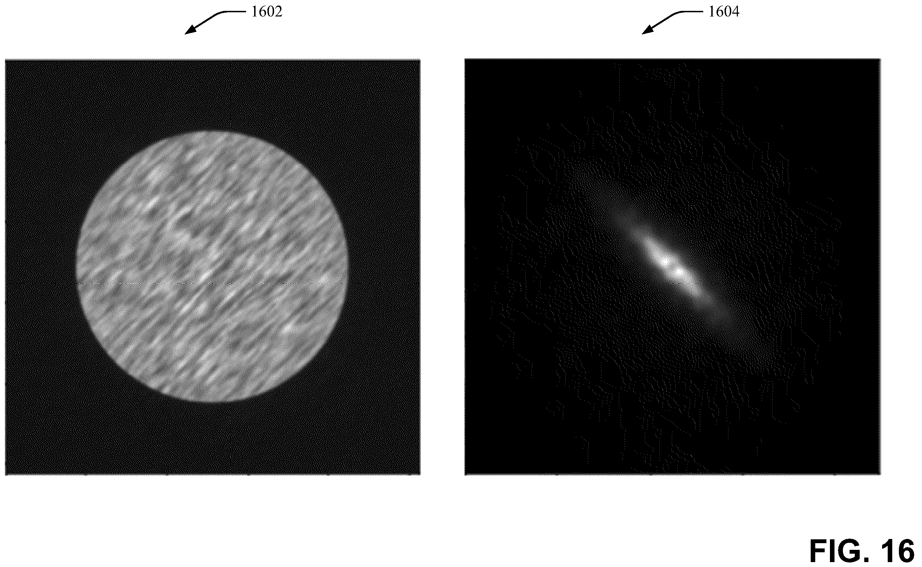

The present inventors experimentally verified various embodiments described herein. Some results of such experimental verification are shown in FIGs. 16-22.

In particular, the present inventors reduced to practice various embodiments in which: the scientific instrument 302 is a transmission electronic microscope; the parametric state 308 is a two-parameter vector, where one parameter represents a microscope defocus aberration coefficient (e.g., measured in nanometers (nm)), and where the other parameter represents a microscope astigmatism aberration coefficient (e.g., measured in nm); and where the iteration-common observable 604 refers to a Fourier transform applied to a CBED pattern of an amorphous carbon specimen.

FIG. 16 illustrates a CBED pattern 1602 of an amorphous carbon specimen. In the experiments conducted by the present inventors, such a CBED pattern could be actually captured by a transmission electron microscope, but such a CBED pattern could also be synthesized or simulated by the digital twin of the transmission electron microscope. FIG. 16 further illustrates the amplitude of a Fourier-transformed CBED pattern 1604. The Fourier-transformed CBED pattern 1604 was obtained by applying a Fourier transform to the CBED pattern 1602 and taking the amplitude of resulting complex numbers.

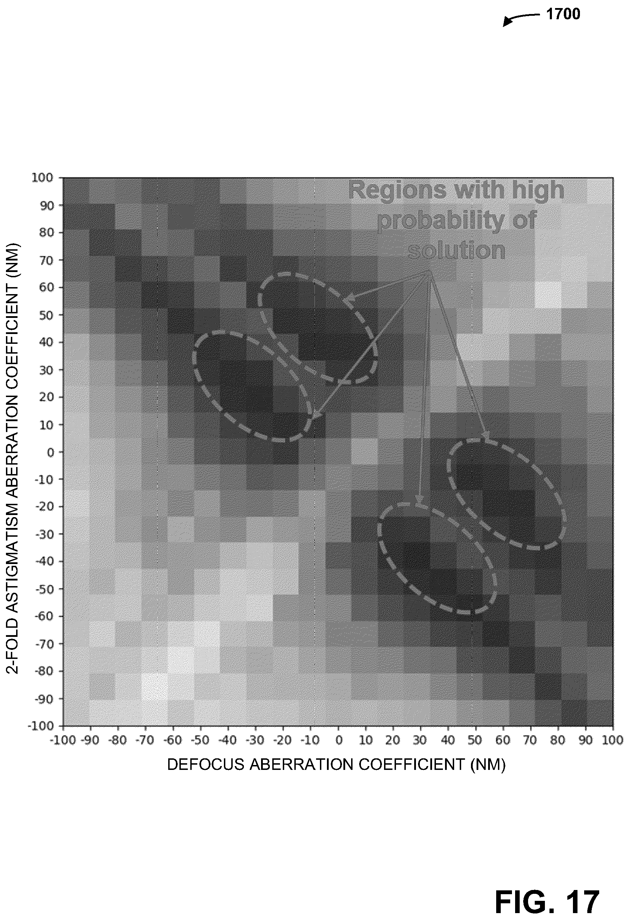

FIG. 17 illustrates a heatmap 1700 that demonstrates a real-world example of the parameter ambiguity problem. Specifically, the abscissa axis of the heatmap 1700 represents at least a portion of a domain of (e.g., possible numerical values that could be assigned to) the microscope defocus aberration coefficient parameter. Additionally, the ordinate axis of the heatmap 1700 represents at least a portion of a domain of (e.g., possible numerical values that could be assigned to) the microscope 2-fold astigmatism aberration coefficient parameter. Those two domains together can be considered as defining the state-space of the digital twin of the transmission electron microscope.

Now, the present inventors caused the transmission electron microscope to capture a real CBED pattern of the amorphous carbon specimen, using some unknown true physical state, and a Fourier transform was applied to that real CBED pattern. Furthermore, the present inventors caused the digital twin to span its state-space with about 400 unique, evenly-spaced-out parametric state instantiations. For each of those parametric state instantiations, the digital twin computed a simulated CBED pattern of the amorphous carbon specimen, and a Fourier transform was applied to each of such simulated CBED patterns.

Finally, a mean squared error was computed between the Fourier-transformed version of the real CBED pattern and the Fourier-transformed version of each of those simulated CBED patterns. Those mean squared errors are displayed in the heatmap 1700, with darker colors representing lower mean squared errors and with lighter colors representing higher mean squared errors. As shown by the dark colored regions of the heatmap 1700, there are many possible parametric state instantiations of the digital twin that yield low mean squared errors (e.g., that predicted a simulated CBED pattern close or similar to the real CBED pattern). But the true physical state of the transmission electron microscope matches only one of those many possible parametric state instantiations. Determining which one of those many possible parametric state instantiations is closest to the true physical state of the transmission electron microscope (e.g., calibrating the digital twin to the transmission electron microscope) is a difficult, non-trivial task. The present inventors demonstrated that various embodiments described herein can correctly, accurately, or reliably facilitate such determination, notwithstanding such difficulty or non-triviality.

Indeed, the present inventors calibrated or synchronized the aberration coefficient parameters of the digital twin to the true physical state of the transmission electron microscope, by leveraging an embodiment of the state-wide Bayesian filter 502.

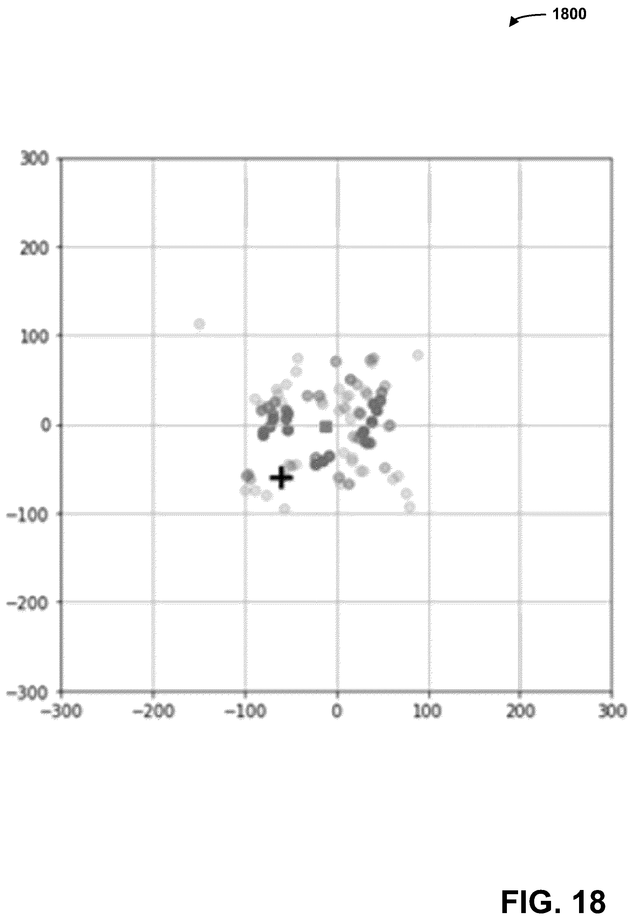

FIG. 18 depicts a graph 1800 that illustrates a first calibration iteration performed by that embodiment of the state-wide Bayesian filter 502. In the graph 1800, the "+" represents the ground-truth physical state of the transmission electron microscope, as estimated using the optiSTEM ^{®} software platform. Also in the graph 1800, each circle represents a respective one of the plurality of sampled parametric state instantiations 802, and the shade or color of each circle represents the weight (e.g., one of 902) corresponding to a respective one of the plurality of sampled parametric state instantiations 802. Specifically, darker colors represent higher weights, whereas lighter colors represent lower weights. As shown, the plurality of sampled parametric state instantiations 802 in the first calibration iteration exhibit wide variance/variability (e.g., they are spread out or not close to each other).

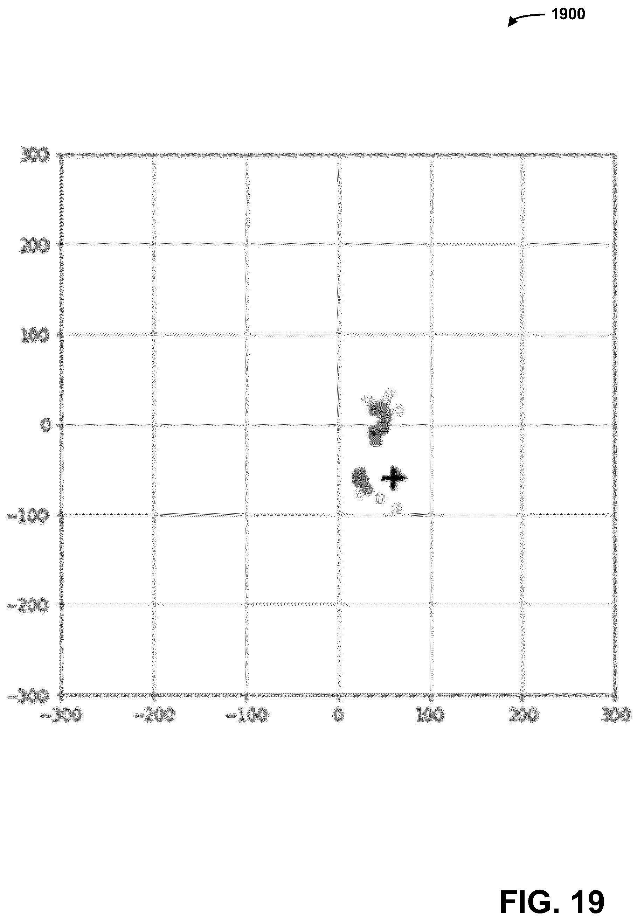

FIG. 19 depicts a graph 1900 that illustrates a second calibration iteration performed by that embodiment of the state-wide Bayesian filter 502. As shown in the graph 1900, the true physical state of the transmission electron microscope has moved, due to the active settings adjustment 1202 performed in the first calibration iteration. Also as shown in the graph 1900, the plurality of sampled parametric state instantiations 802 have moved closer to each other and are incrementally more tightly packed around or near the true physical state.

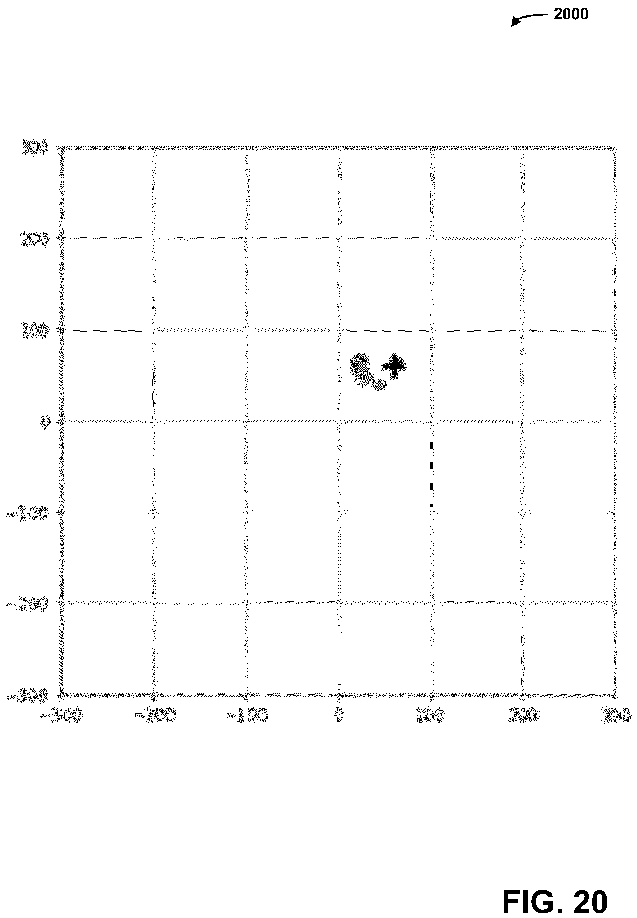

FIG. 20 depicts a graph 2000 that illustrates a third calibration iteration performed by that embodiment of the state-wide Bayesian filter 502. As shown in the graph 2000, the true physical state of the transmission electron microscope has moved again, due to the active settings adjustment 1202 performed in the second calibration iteration. Also as shown in the graph 2000, the plurality of sampled parametric state instantiations 802 have moved even closer to each other and are even more tightly packed around or near the true physical state.

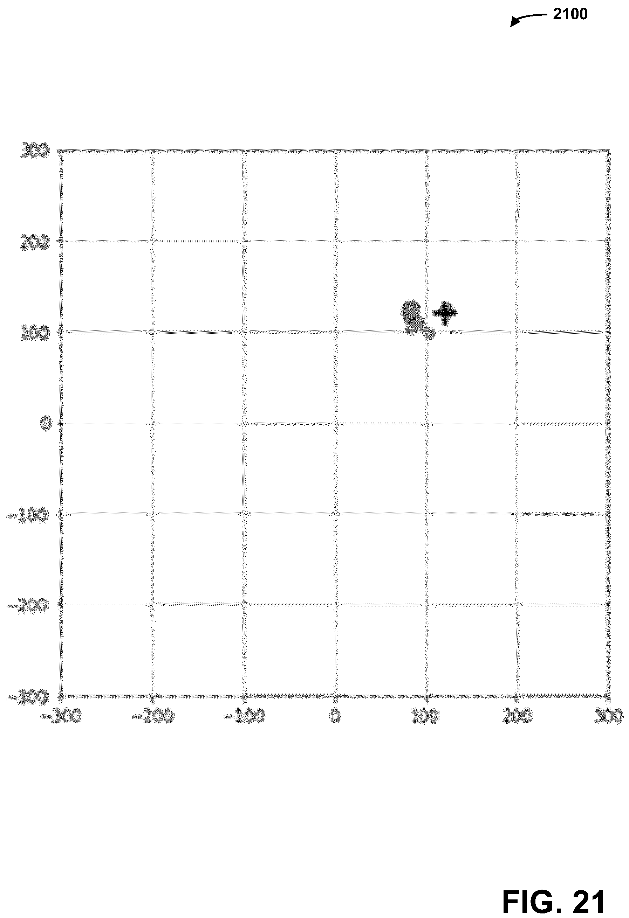

FIG. 21 depicts a graph 2100 that illustrates a fourth calibration iteration performed by that embodiment of the state-wide Bayesian filter 502. As shown in the graph 2100, the true physical state of the transmission electron microscope has moved yet again, due to the active settings adjustment 1202 performed in the third calibration iteration. Also as shown in the graph 2100, the plurality of sampled parametric state instantiations 802 have moved still closer to each other and are still more tightly packed around or near the true physical state.

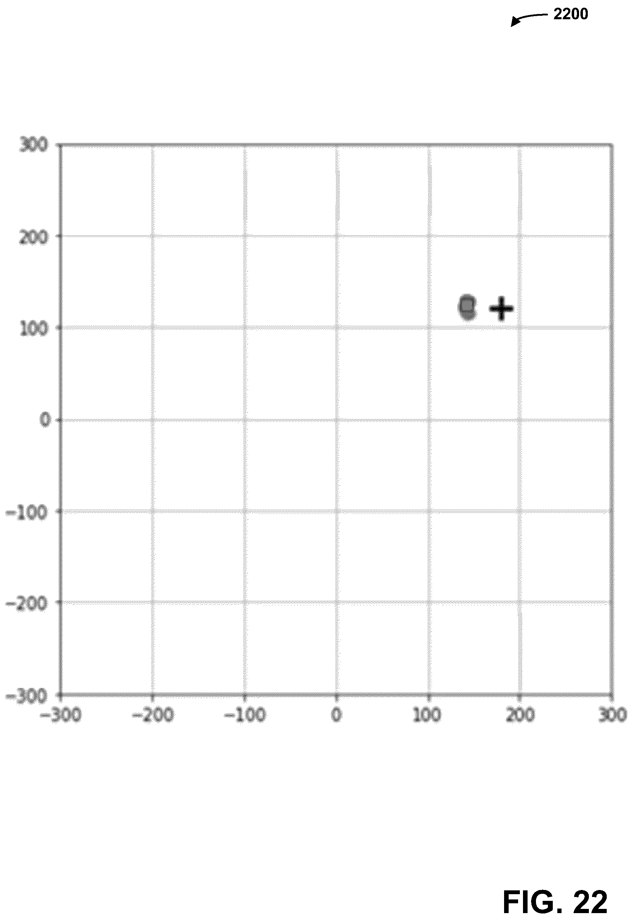

FIG. 22 depicts a graph 2200 that illustrates a fifth calibration iteration performed by that embodiment of the state-wide Bayesian filter 502. As shown in the graph 2200, the true physical state of the transmission electron microscope has moved once more, due to the active settings adjustment 1202 performed in the fourth calibration iteration. Also as shown in the graph 2200, the plurality of sampled parametric state instantiations 802 are now extremely close to each other and are sufficiently close to the true physical state.

Accordingly, FIGs. 16-22 can be considered as showing how various embodiments described herein were able to accurately calibrate or synchronize microscope aberration coefficient parameters of the digital twin with the true physical state of the transmission electron microscope, notwithstanding the parameter ambiguity problem. As explained throughout this disclosure, such accurate calibration or synchronization can be accomplished due to: the state-wide Bayesian filter 502 incrementally updating all of the parameters of the digital twin 306 at each calibration iteration, rather than updating different parameters in different iterations in order of dependency; and the state-wide Bayesian filter 502 utilizing a single, common observable (e.g., Fourier-transformed CBED pattern) in all of the calibration iterations, rather than utilizing different observables in different iterations.

Although various embodiments described herein involve the iteration-common observable 604 being a Fourier-transformed version of a CBED pattern (e.g., of a Ronchigram) depicting an amorphous carbon specimen, these are mere non-limiting examples for ease of explanation and illustration. In various aspects, the iteration-common observable 604 can take any other form or be expressed according to any other data representation. Indeed, in some cases, the iteration-common observable 604 can be a CBED pattern that has undergone some transformation other than a Fourier transform. A non-limiting example of such other type of transformation can be any suitable feature extraction, such as edge, sift, power spectrum, or patching. In yet other cases, the iteration-common observable 604 can be a CBED pattern that has not undergone any transformation at all. In even other cases, the iteration-common observable 604 can be a CBED pattern of any suitable non-carbon specimen or non-amorphous specimen.

Although the herein figures show that the system 314 can be within or local to the scientific instrument 302, this is a mere non-limiting example for ease of explanation and illustration. In various other embodiments, the system 314 can instead be remote from the scientific instrument 302. Indeed, in some cases, the system 314 can be implemented on a specialized computer that is designed or configured for controlling one or more scientific instruments, performing post-measurement analyses for one or more scientific instruments, or otherwise computationally supporting one or more scientific instruments.

Note that an aberration coefficient of a charged-particle microscope can, in various aspects, not be considered as a global characteristic of the charged-particle microscope. Indeed, the substantive content or meaning of an aberration coefficient of the charged-particle microscope can vary with different locations along an optical axis of the charged-particle microscope. As a non-limiting example, if a beam of the charged-particle microscope is focused on a specimen, aberration coefficients can be defined in a condenser aperture plane of the charged-particle microscope. In such case, the aberration coefficients can be referred to as probe aberrations of the charged-particle microscope. As another non-limiting example, if a beam of the charged-particle microscope is instead parallel to the specimen, aberration coefficients can be defined in a specimen plane of the charged-particle microscope. In such case, the aberration coefficients can be referred to as image aberrations. Accordingly, as described herein, the term "aberration coefficient" can be considered as a hypernym or umbrella term that includes or encompasses any suitable types of aberrations defined with respect to any suitable locations along an optical axis of a charged-particle microscope.

Note that, in some aspects, the system 314 can be implemented, activated, or otherwise invoked periodically, continuously, or continually so as to more frequently cause the parametric state 308 of the digital twin 306 to be synchronized or otherwise calibrated with the physical state of the scientific instrument 302. In other aspects, however, the system 314 can instead be implemented, activated, or otherwise invoked in aperiodic or *ad hoc* fashion, so as to less frequently cause the parametric state 308 of the digital twin 306 to be synchronized or otherwise calibrated with the physical state of the scientific instrument 302.

The scientific instrument systems, methods, or techniques disclosed herein may include interactions with a human user (e.g., via a user local computing device 2520 discussed herein with reference to FIG. 25). These interactions may include providing information to the user (e.g., information regarding the operation of a scientific instrument such as the scientific instrument 2510 of FIG. 25, information regarding a sample being analyzed or other test or measurement performed by a scientific instrument, information retrieved from a local or remote database, or other information) or providing an option for a user to input commands (e.g., to control the operation of a scientific instrument such as the scientific instrument 2510 of FIG. 25, or to control the analysis of data generated by a scientific instrument), queries (e.g., to a local or remote database), or other information. In some embodiments, these interactions may be performed through a graphical user interface (GUI) that includes a visual display on a display device (e.g., a display device 2410 discussed herein with reference to FIG. 24) that provides outputs to the user and/or prompts the user to provide inputs (e.g., via one or more input devices, such as a keyboard, mouse, trackpad, or touchscreen, included in other I/O devices 2412 discussed herein with reference to FIG. 24). The scientific instrument systems, methods, or techniques disclosed herein may include any suitable GUIs for interaction with a user.

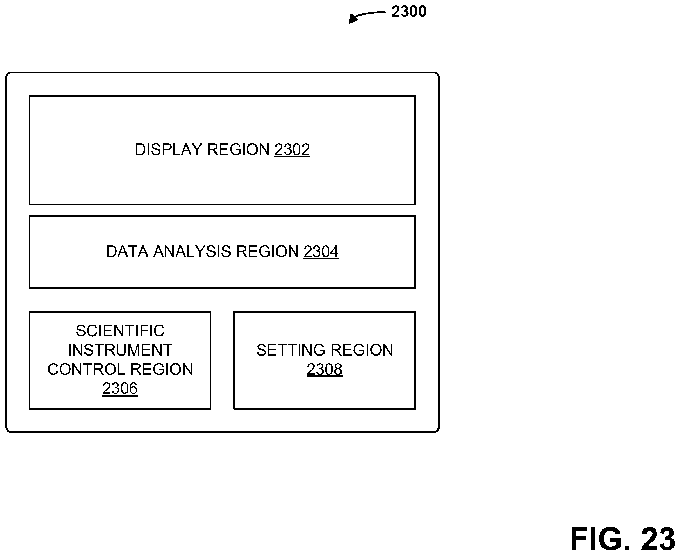

FIG. 23 depicts an example graphical user interface 2300 (hereafter "GUI 2300") that can be used in the performance of some or all of the support methods or techniques disclosed herein, in accordance with various embodiments. In various aspects, the GUI 2300 can be provided on any suitable electronic display (e.g., a display device 2410 discussed herein with reference to FIG. 24) of a computing device (e.g., a computing device 2400 discussed herein with reference to FIG. 24) of a scientific instrument support system (e.g., a scientific instrument support system 2500 discussed herein with reference to FIG. 25), and a user or technician can interact with the GUI 2300 using any suitable input device (e.g., any of other I/O devices 2412 discussed herein with reference to FIG. 24) and input technique (e.g., movement of a cursor, motion capture, facial recognition, gesture detection, voice recognition, actuation of buttons).

The GUI 2300 can include a data display region 2302, a data analysis region 2304, a scientific instrument control region 2306, and a setting region 2308. The particular number and arrangement of regions depicted in FIG. 23 is merely illustrative, and any number and arrangement of regions, including any desired features, can be included in other embodiments of the GUI 2300.

The data display region 2302 can display data generated by a scientific instrument (e.g., a scientific instrument 2510 discussed herein with reference to FIG. 25).

The data analysis region 2304 can display any suitable data analysis results (e.g., the results of analyzing the data illustrated in the data display region 2302 or other data). In some embodiments, the data display region 2302 and the data analysis region 2304 can be combined in the GUI 2300 (e.g., to include both data output from a scientific instrument and some analysis of the data in a common graph or region).

The scientific instrument control region 2306 can include options that allow a user or technician to control a scientific instrument (e.g., the scientific instrument 2510 discussed herein with reference to FIG. 25). For example, the scientific instrument control region 2306 can include configurable parameters that govern operation of such scientific instrument (e.g., configurable parameters that govern voltages or electric currents of the scientific instrument, that govern interior temperatures of the scientific instrument, or that govern fluid flow rates of the scientific instrument).

The setting region 2308 can include options that allow a user or technician to control any features or functions of the GUI 2300 (or of other GUIs) or to perform common computing operations with respect to the data display region 2302 and the data analysis region 2304 (e.g., saving data on a storage device, such as the storage device 2404 discussed herein with reference to FIG. 24, sending data to another user, labeling data).

As noted above, the scientific instrument module 102 can be implemented by one or more computing devices. FIG. 24 is a block diagram of a computing device 2400 that can perform some or all of the scientific instrument methods or techniques disclosed herein, in accordance with various embodiments. In some embodiments, the scientific instrument module 102 can be implemented by a single instance of the computing device 2400 or by multiple instances of the computing device 2400. Further, as discussed below, the computing device 2400 (or multiple instances thereof) that implements the scientific instrument module 102 can be part of one or more of a scientific instrument 2510, a user local computing device 2520, a service local computing device 2530, or a remote computing device 2540 of FIG. 25.

The computing device 2400 is illustrated as having a number of components, but any one or more of these components can be omitted or duplicated, as suitable for the application and setting. In some embodiments, some or all of the components included in the computing device 2400 can be attached to one or more motherboards and enclosed in a housing (e.g., including plastic, metal, or other materials). In some embodiments, some these components can be fabricated onto a single system-on-a-chip (SoC) (e.g., an SoC may include one or more instances of a processing device 2402 and one or more instances of a storage device 2404). Additionally, in various embodiments, the computing device 2400 can omit one or more of the components illustrated in FIG. 24, but can include interface circuitry (not shown) for coupling to the one or more omitted components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface). For example, the computing device 2400 can omit a display device 2410, but can include display device interface circuitry (e.g., a connector and driver circuitry) to which a display device 2410 can be coupled.

The computing device 2400 can include a processing device 2402 (e.g., one or more processing devices). As used herein, the term "processing device" can refer to any device or portion of a device that processes electronic data from registers or memory to transform that electronic data into other electronic data that may be stored in registers or memories. The processing device 2402 can include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 2400 can include a storage device 2404 (e.g., one or more storage devices). The storage device 2404 can include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 2404 can include memory that shares a die with a processing device 2402. In such an embodiment, the memory may be used as cache memory and may include embedded dynamic random access memory (eDRAM) or spin transfer torque magnetic random access memory (STT-MRAM), for example. In some embodiments, the storage device 2404 can include non-transitory computer readable media having instructions thereon that, when executed by one or more processing devices (e.g., the processing device 2402), cause the computing device 2400 to perform any appropriate ones of or portions of the methods disclosed herein.

The computing device 2400 can include an interface device 2406 (e.g., one or more instances of the interface device 2406). The interface device 2406 can include one or more communication chips, connectors, or other hardware and software to govern communications between the computing device 2400 and other computing devices. For example, the interface device 2406 can include circuitry for managing wireless communications for the transfer of data to and from the computing device 2400. The term "wireless" and its derivatives may be used to describe circuits, devices, systems, methods, techniques, or communications channels that may communicate data through the use of modulated electromagnetic radiation through a nonsolid medium. The term does not imply that the associated devices do not contain any wires, although in some embodiments they might not. Circuitry included in the interface device 2406 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2")). In some embodiments, circuitry included in the interface device 2406 for managing wireless communications can operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 2406 for managing wireless communications can operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 2406 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 2406 may include one or more antennas (e.g., one or more antenna arrays) to receipt and/or transmission of wireless communications.

In some embodiments, the interface device 2406 can include circuitry for managing wired communications, such as electrical, optical, or any other suitable communication protocols. For example, the interface device 2406 can include circuitry to support communications in accordance with Ethernet technologies. In some embodiments, the interface device 2406 can support both wireless and wired communication, or can support multiple wired communication protocols or multiple wireless communication protocols. For example, a first set of circuitry of the interface device 2406 may be dedicated to shorter-range wireless communications such as Wi-Fi or Bluetooth, and a second set of circuitry of the interface device 2406 may be dedicated to longer-range wireless communications such as global positioning system (GPS), EDGE, GPRS, CDMA, WiMAX, LTE, EV-DO, or others. In some embodiments, a first set of circuitry of the interface device 2406 can be dedicated to wireless communications, and a second set of circuitry of the interface device 2406 can be dedicated to wired communications.

The computing device 2400 can include battery/power circuitry 2408. The battery/power circuitry 2408 can include one or more energy storage devices (e.g., batteries or capacitors) or circuitry for coupling components of the computing device 2400 to an energy source separate from the computing device 2400 (e.g., alternating current line power).

The computing device 2400 can include a display device 2410 (e.g., multiple display devices). The display device 2410 can include any visual indicators, such as a heads-up display, a computer monitor, a projector, a touchscreen display, a liquid crystal display (LCD), a light-emitting diode display, or a flat panel display.

The computing device 2400 can include other input/output (I/O) devices 2412. The other I/O devices 2412 can include one or more audio output devices (e.g., speakers, headsets, earbuds, alarms), one or more audio input devices (e.g., microphones or microphone arrays), location devices (e.g., GPS devices in communication with a satellite-based system to receive a location of the computing device 2400), audio codecs, video codecs, printers, sensors (e.g., thermocouples or other temperature sensors, humidity sensors, pressure sensors, vibration sensors, accelerometers, gyroscopes), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 2400 can have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer), a desktop computing device, or a server computing device or other networked computing component.

One or more computing devices implementing any of the scientific instrument modules, methods, or techniques disclosed herein may be part of a scientific instrument support system. FIG. 25 is a block diagram of an example scientific instrument support system 2500 in which some or all of the scientific instrument support methods disclosed herein may be performed, in accordance with various embodiments. The scientific instrument modules, methods, or techniques disclosed herein (e.g., the scientific instrument module 102, the computer-implemented method 200, the system 314, the computer-implemented methods 1300-1500) can be implemented by one or more of a scientific instrument 2510, a user local computing device 2520, a service local computing device 2530, or a remote computing device 2540 of the scientific instrument support system 2500.

Any of the scientific instrument 2510, the user local computing device 2520, the service local computing device 2530, or the remote computing device 2540 can include any of the embodiments of the computing device 2400, and any of the scientific instrument 2510, the user local computing device 2520, the service local computing device 2530, or the remote computing device 2540 can take the form of any appropriate ones of the embodiments of the computing device 2400.

The scientific instrument 2510, the user local computing device 2520, the service local computing device 2530, or the remote computing device 2540 may each include a processing device 2502, a storage device 2504, and an interface device 2506. The processing device 2502 may take any suitable form, including any form of the processing device 2402, and the processing devices 2502 included in different ones of the scientific instrument 2510, the user local computing device 2520, the service local computing device 2530, or the remote computing device 2540 may take the same form or different forms. The storage device 2504 may take any suitable form, including any form of the storage device 2404, and the storage devices 2504 included in different ones of the scientific instrument 2510, the user local computing device 2520, the service local computing device 2530, or the remote computing device 2540 may take the same form or different forms. The interface device 2506 may take any suitable form, including any form of the interface device 2406, and the interface devices 2506 included in different ones of the scientific instrument 2510, the user local computing device 2520, the service local computing device 2530, or the remote computing device 2540 may take the same form or different forms.

The scientific instrument 2510, the user local computing device 2520, the service local computing device 2530, and the remote computing device 2540 can be in communication with other elements of the scientific instrument support system 2500 via communication pathways 2508. The communication pathways 2508 may communicatively couple the interface devices 2506 of different ones of the elements of the scientific instrument support system 2500, as shown, and may be wired or wireless communication pathways (e.g., in accordance with any of the communication techniques discussed herein with reference to the interface device 2406). The particular scientific instrument support system 2500 depicted in FIG. 25 includes communication pathways between each pair of the scientific instrument 2510, the user local computing device 2520, the service local computing device 2530, and the remote computing device 2540, but this "fully connected" implementation is merely illustrative, and in various embodiments, various ones of the communication pathways 2508 may be absent. For example, in some embodiments, a service local computing device 2530 can lack a direct communication pathway 2508 between its interface device 2506 and the interface device 2506 of the scientific instrument 2510, but can instead communicate with the scientific instrument 2510 via the communication pathway 2508 between the service local computing device 2530 and the user local computing device 2520 and the communication pathway 2508 between the user local computing device 2520 and the scientific instrument 2510.

The scientific instrument 2510 may include any appropriate scientific instrument, such as the scientific instrument 302.

The user local computing device 2520 can be a computing device (e.g., in accordance with any of the embodiments of the computing device 2400) that is local to a user of the scientific instrument 2510. In some embodiments, the user local computing device 2520 may also be local to the scientific instrument 2510, but this need not be the case; for example, a user local computing device 2520 that is in a user's home or office may be remote from, but in communication with, the scientific instrument 2510 so that the user may use the user local computing device 2520 to control or access data from the scientific instrument 2510. In some embodiments, the user local computing device 2520 may be a laptop, smartphone, or tablet device. In some embodiments the user local computing device 2520 can be a portable computing device.

The service local computing device 2530 can be a computing device (e.g., in accordance with any of the embodiments of the computing device 2400) that is local to an entity that services the scientific instrument 2510. For example, the service local computing device 2530 may be local to a manufacturer of the scientific instrument 2510 or to a third-party service company. In some embodiments, the service local computing device 2530 can communicate with the scientific instrument 2510, the user local computing device 2520, or the remote computing device 2540 (e.g., via a direct communication pathway 2508 or via multiple "indirect" communication pathways 2508, as discussed above) to receive data regarding the operation of the scientific instrument 2510, the user local computing device 2520, or the remote computing device 2540 (e.g., the results of self-tests of the scientific instrument 2510, calibration coefficients used by the scientific instrument 2510, the measurements of sensors associated with the scientific instrument 2510). In some embodiments, the service local computing device 2530 may communicate with the scientific instrument 2510, the user local computing device 2520, or the remote computing device 2540 (e.g., via a direct communication pathway 2508 or via multiple "indirect" communication pathways 2508, as discussed above) to transmit data to the scientific instrument 2510, the user local computing device 2520, or the remote computing device 2540 (e.g., to update programmed instructions, such as firmware, in the scientific instrument 2510, to initiate the performance of test or calibration sequences in the scientific instrument 2510, to update programmed instructions, such as software, in the user local computing device 2520 or the remote computing device 2540). A user of the scientific instrument 2510 can utilize the scientific instrument 2510 or the user local computing device 2520 to communicate with the service local computing device 2530 to report a problem with the scientific instrument 2510 or the user local computing device 2520, to request a visit from a technician to improve the operation of the scientific instrument 2510, to order consumables or replacement parts associated with the scientific instrument 2510, or for other purposes.

The remote computing device 2540 can be a computing device (e.g., in accordance with any of the embodiments of the computing device 2400 discussed herein) that is remote from the scientific instrument 2510 or from the user local computing device 2520. In some embodiments, the remote computing device 2540 can be included in a datacenter or other large-scale server environment. In some embodiments, the remote computing device 2540 may include network-attached storage (e.g., as part of the storage device 2504). The remote computing device 2540 can store data generated by the scientific instrument 2510, perform analyses of the data generated by the scientific instrument 2510 (e.g., in accordance with programmed instructions), facilitate communication between the user local computing device 2520 and the scientific instrument 2510, or facilitate communication between the service local computing device 2530 and the scientific instrument 2510.

In some embodiments, one or more of the elements of the scientific instrument support system 2500 illustrated in FIG. 25 can be omitted. Further, in some embodiments, multiple ones of various ones of the elements of the scientific instrument support system 2500 of FIG. 25 may be present. For example, a scientific instrument support system 2500 can include multiple user local computing devices 2520 (e.g., different user local computing devices 2520 associated with different users or in different locations). In another example, a scientific instrument support system 2500 may include multiple scientific instruments 2510, all in communication with service local computing device 2530 and/or a remote computing device 2540; in such an embodiment, the service local computing device 2530 may monitor these multiple scientific instruments 2510, and the service local computing device 2530 may cause updates or other information may be "broadcast" to multiple scientific instruments 2510 at the same time. Different ones of the scientific instruments 2510 in a scientific instrument support system 2500 can be located close to one another (e.g., in the same room) or farther from one another (e.g., on different floors of a building, in different buildings, in different cities, etc.). In some embodiments, a scientific instrument 2510 can be connected to an Internet-of-Things (IoT) stack that allows for command and control of the scientific instrument 2510 through a web-based application, a virtual or augmented reality application, a mobile application, or a desktop application. Any of these applications can be accessed by a user operating the user local computing device 2520 in communication with the scientific instrument 2510 by the intervening remote computing device 2540. In some embodiments, a scientific instrument 2510 may be sold by the manufacturer along with one or more associated user local computing devices 2520 as part of a local scientific instrument computing unit 2512.

In some embodiments, different ones of the scientific instruments 2510 included in a scientific instrument support system 2500 may be different types of scientific instruments 2510; for example, one scientific instrument 2510 may be a mass spectrometer, while another scientific instrument 2510 may be a chromatograph or autosampler. In some such embodiments, the remote computing device 2540 or the user local computing device 2520 can combine data from different types of scientific instruments 2510 included in a scientific instrument support system 2500.

In various instances, machine learning algorithms or models can be implemented in any suitable way to facilitate any suitable aspects described herein. To facilitate some of the above-described machine learning aspects of various embodiments, consider the following discussion of artificial intelligence (Al). Various embodiments described herein can employ artificial intelligence to facilitate automating one or more features or functionalities. The components can employ various Al-based schemes for carrying out various embodiments/examples disclosed herein. In order to provide for or aid in the numerous determinations (e.g., determine, ascertain, infer, calculate, predict, prognose, estimate, derive, forecast, detect, compute) described herein, components described herein can examine the entirety or a subset of the data to which it is granted access and can provide for reasoning about or determine states of the system or environment from a set of observations as captured via events or data. Determinations can be employed to identify a specific context or action, or can generate a probability distribution over states, for example. The determinations can be probabilistic; that is, the computation of a probability distribution over states of interest based on a consideration of data and events. Determinations can also refer to techniques employed for composing higher-level events from a set of events or data.

Such determinations can result in the construction of new events or actions from a set of observed events or stored event data, whether or not the events are correlated in close temporal proximity, and whether the events and data come from one or several event and data sources. Components disclosed herein can employ various classification (explicitly trained (e.g., via training data) as well as implicitly trained (e.g., via observing behavior, preferences, historical information, receiving extrinsic information, and so on)) schemes or systems (e.g., support vector machines, neural networks, expert systems, Bayesian belief networks, fuzzy logic, data fusion engines, and so on) in connection with performing automatic or determined action in connection with the claimed subject matter. Thus, classification schemes or systems can be used to automatically learn and perform a number of functions, actions, or determinations.

A classifier can map an input attribute vector, z = (z₁, z₂, z₃, z₄, *zₙ*)*,* to a confidence that the input belongs to a class, as by f(z) = *confidence*(*class*). Such classification can employ a probabilistic or statistical-based analysis (e.g., factoring into the analysis utilities and costs) to determinate an action to be automatically performed. A support vector machine (SVM) can be an example of a classifier that can be employed. The SVM operates by finding a hyper-surface in the space of possible inputs, where the hyper-surface attempts to split the triggering criteria from the non-triggering events. Intuitively, this makes the classification correct for testing data that is near, but not identical to training data. Other directed and undirected model classification approaches include, e.g., naive Bayes, Bayesian networks, decision trees, neural networks, fuzzy logic models, or probabilistic classification models providing different patterns of independence, any of which can be employed. Classification as used herein also is inclusive of statistical regression that is utilized to develop models of priority.

In order to provide additional context for various embodiments described herein, FIG. 26 and the following discussion are intended to provide a brief, general description of a suitable computing environment 2600 in which the various embodiments of the embodiment described herein can be implemented. While the embodiments have been described above in the general context of computer-executable instructions that can run on one or more computers, those skilled in the art will recognize that the embodiments can be also implemented in combination with other program modules or as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multi-processor computer systems, minicomputers, mainframe computers, Internet of Things (loT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 26, the example environment 2600 for implementing various embodiments of the aspects described herein includes a computer 2602, the computer 2602 including a processing unit 2604, a system memory 2606 and a system bus 2608. The system bus 2608 couples system components including, but not limited to, the system memory 2606 to the processing unit 2604. The processing unit 2604 can be any of various commercially available processors. Dual microprocessors and other multi processor architectures can also be employed as the processing unit 2604.

The system bus 2608 can be any of several types of bus structure that can further interconnect to a memory bus (with or without a memory controller), a peripheral bus, and a local bus using any of a variety of commercially available bus architectures. The system memory 2606 includes ROM 2610 and RAM 2612. A basic input/output system (BIOS) can be stored in a non-volatile memory such as ROM, erasable programmable read only memory (EPROM), EEPROM, which BIOS contains the basic routines that help to transfer information between elements within the computer 2602, such as during startup. The RAM 2612 can also include a high-speed RAM such as static RAM for caching data.

The computer 2602 further includes an internal hard disk drive (HDD) 2614 (e.g., EIDE, SATA), one or more external storage devices 2616 (e.g., a magnetic floppy disk drive (FDD) 2616, a memory stick or flash drive reader, a memory card reader, etc.) and a drive 2620, e.g., such as a solid state drive, an optical disk drive, which can read or write from a disk 2622, such as a CD-ROM disc, a DVD, a BD, etc. Alternatively, where a solid state drive is involved, disk 2622 would not be included, unless separate. While the internal HDD 2614 is illustrated as located within the computer 2602, the internal HDD 2614 can also be configured for external use in a suitable chassis (not shown). Additionally, while not shown in environment 2600, a solid state drive (SSD) could be used in addition to, or in place of, an HDD 2614. The HDD 2614, external storage device(s) 2616 and drive 2620 can be connected to the system bus 2608 by an HDD interface 2624, an external storage interface 2626 and a drive interface 2628, respectively. The interface 2624 for external drive implementations can include at least one or both of Universal Serial Bus (USB) and Institute of Electrical and Electronics Engineers (IEEE) 1394 interface technologies. Other external drive connection technologies are within contemplation of the embodiments described herein.

The drives and their associated computer-readable storage media provide nonvolatile storage of data, data structures, computer-executable instructions, and so forth. For the computer 2602, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 2612, including an operating system 2630, one or more application programs 2632, other program modules 2634 and program data 2636. All or portions of the operating system, applications, modules, or data can also be cached in the RAM 2612. The systems and methods described herein can be implemented utilizing various commercially available operating systems or combinations of operating systems.

Computer 2602 can optionally comprise emulation technologies. For example, a hypervisor (not shown) or other intermediary can emulate a hardware environment for operating system 2630, and the emulated hardware can optionally be different from the hardware illustrated in FIG. 26. In such an embodiment, operating system 2630 can comprise one virtual machine (VM) of multiple VMs hosted at computer 2602. Furthermore, operating system 2630 can provide runtime environments, such as the Java runtime environment or the .NET framework, for applications 2632. Runtime environments are consistent execution environments that allow applications 2632 to run on any operating system that includes the runtime environment. Similarly, operating system 2630 can support containers, and applications 2632 can be in the form of containers, which are lightweight, standalone, executable packages of software that include, e.g., code, runtime, system tools, system libraries and settings for an application.

Further, computer 2602 can be enabled with a security module, such as a trusted processing module (TPM). For instance with a TPM, boot components hash next in time boot components, and wait for a match of results to secured values, before loading a next boot component. This process can take place at any layer in the code execution stack of computer 2602, e.g., applied at the application execution level or at the operating system (OS) kernel level, thereby enabling security at any level of code execution.

A user can enter commands and information into the computer 2602 through one or more wired/wireless input devices, e.g., a keyboard 2638, a touch screen 2640, and a pointing device, such as a mouse 2642. Other input devices (not shown) can include a microphone, an infrared (IR) remote control, a radio frequency (RF) remote control, or other remote control, a joystick, a virtual reality controller or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 2604 through an input device interface 2644 that can be coupled to the system bus 2608, but can be connected by other interfaces, such as a parallel port, an IEEE 1394 serial port, a game port, a USB port, an IR interface, a BLUETOOTH^{®} interface, etc.

A monitor 2646 or other type of display device can be also connected to the system bus 2608 via an interface, such as a video adapter 2648. In addition to the monitor 2646, a computer typically includes other peripheral output devices (not shown), such as speakers, printers, etc.

The computer 2602 can operate in a networked environment using logical connections via wired or wireless communications to one or more remote computers, such as a remote computer(s) 2650. The remote computer(s) 2650 can be a workstation, a server computer, a router, a personal computer, portable computer, microprocessor-based entertainment appliance, a peer device or other common network node, and typically includes many or all of the elements described relative to the computer 2602, although, for purposes of brevity, only a memory/storage device 2652 is illustrated. The logical connections depicted include wired/wireless connectivity to a local area network (LAN) 2654 or larger networks, e.g., a wide area network (WAN) 2656. Such LAN and WAN networking environments are commonplace in offices and companies, and facilitate enterprise-wide computer networks, such as intranets, all of which can connect to a global communications network, e.g., the Internet.

When used in a LAN networking environment, the computer 2602 can be connected to the local network 2654 through a wired or wireless communication network interface or adapter 2658. The adapter 2658 can facilitate wired or wireless communication to the LAN 2654, which can also include a wireless access point (AP) disposed thereon for communicating with the adapter 2658 in a wireless mode.

When used in a WAN networking environment, the computer 2602 can include a modem 2660 or can be connected to a communications server on the WAN 2656 via other means for establishing communications over the WAN 2656, such as by way of the Internet. The modem 2660, which can be internal or external and a wired or wireless device, can be connected to the system bus 2608 via the input device interface 2644. In a networked environment, program modules depicted relative to the computer 2602 or portions thereof, can be stored in the remote memory/storage device 2652. It will be appreciated that the network connections shown are example and other means of establishing a communications link between the computers can be used.

When used in either a LAN or WAN networking environment, the computer 2602 can access cloud storage systems or other network-based storage systems in addition to, or in place of, external storage devices 2616 as described above, such as but not limited to a network virtual machine providing one or more aspects of storage or processing of information. Generally, a connection between the computer 2602 and a cloud storage system can be established over a LAN 2654 or WAN 2656 e.g., by the adapter 2658 or modem 2660, respectively. Upon connecting the computer 2602 to an associated cloud storage system, the external storage interface 2626 can, with the aid of the adapter 2658 or modem 2660, manage storage provided by the cloud storage system as it would other types of external storage. For instance, the external storage interface 2626 can be configured to provide access to cloud storage sources as if those sources were physically connected to the computer 2602.

The computer 2602 can be operable to communicate with any wireless devices or entities operatively disposed in wireless communication, e.g., a printer, scanner, desktop or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a predefined structure as with a conventional network or simply an ad hoc communication between at least two devices.

FIG. 27 is a schematic block diagram of a sample computing environment 2700 with which the disclosed subject matter can interact. The sample computing environment 2700 includes one or more client(s) 2710. The client(s) 2710 can be hardware or software (e.g., threads, processes, computing devices). The sample computing environment 2700 also includes one or more server(s) 2730. The server(s) 2730 can also be hardware or software (e.g., threads, processes, computing devices). The servers 2730 can house threads to perform transformations by employing one or more embodiments as described herein, for example. One possible communication between a client 2710 and a server 2730 can be in the form of a data packet adapted to be transmitted between two or more computer processes. The sample computing environment 2700 includes a communication framework 2750 that can be employed to facilitate communications between the client(s) 2710 and the server(s) 2730. The client(s) 2710 are operably connected to one or more client data store(s) 2720 that can be employed to store information local to the client(s) 2710. Similarly, the server(s) 2730 are operably connected to one or more server data store(s) 2740 that can be employed to store information local to the servers 2730.

Various embodiments may be a system, a method, an apparatus or a computer program product at any possible technical detail level of integration. The computer program product can include a computer readable storage medium (or media) having computer readable program instructions thereon for causing a processor to carry out aspects of various embodiments. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network or a wireless network. The network can comprise copper transmission cables, optical transmission fibers, wireless transmission, routers, firewalls, switches, gateway computers or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of various embodiments can be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions can execute entirely on the user's computer, partly on the user's computer, as a stand-alone software package, partly on the user's computer and partly on a remote computer or entirely on the remote computer or server. In the latter scenario, the remote computer can be connected to the user's computer through any type of network, including a local area network (LAN) or a wide area network (WAN), or the connection can be made to an external computer (for example, through the Internet using an Internet Service Provider). In some embodiments, electronic circuitry including, for example, programmable logic circuitry, field-programmable gate arrays (FPGA), or programmable logic arrays (PLA) can execute the computer readable program instructions by utilizing state information of the computer readable program instructions to personalize the electronic circuitry, in order to perform various aspects.

Various aspects are described herein with reference to flowchart illustrations or block diagrams of methods, apparatus (systems), and computer program products according to various embodiments. It will be understood that each block of the flowchart illustrations or block diagrams, and combinations of blocks in the flowchart illustrations or block diagrams, can be implemented by computer readable program instructions. These computer readable program instructions can be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart or block diagram block or blocks. These computer readable program instructions can also be stored in a computer readable storage medium that can direct a computer, a programmable data processing apparatus, or other devices to function in a particular manner, such that the computer readable storage medium having instructions stored therein comprises an article of manufacture including instructions which implement aspects of the function/act specified in the flowchart or block diagram block or blocks. The computer readable program instructions can also be loaded onto a computer, other programmable data processing apparatus, or other device to cause a series of operational acts to be performed on the computer, other programmable apparatus or other device to produce a computer implemented process, such that the instructions which execute on the computer, other programmable apparatus, or other device implement the functions/acts specified in the flowchart or block diagram block or blocks.

The flowcharts and block diagrams in the Figures illustrate the architecture, functionality, and operation of possible implementations of systems, methods, and computer program products according to various embodiments. In this regard, each block in the flowchart or block diagrams can represent a module, segment, or portion of instructions, which comprises one or more executable instructions for implementing the specified logical function(s). In some alternative implementations, the functions noted in the blocks can occur out of the order noted in the Figures. For example, two blocks shown in succession can, in fact, be executed substantially concurrently, or the blocks can sometimes be executed in the reverse order, depending upon the functionality involved. It will also be noted that each block of the block diagrams or flowchart illustration, and combinations of blocks in the block diagrams or flowchart illustration, can be implemented by special purpose hardware-based systems that perform the specified functions or acts or carry out combinations of special purpose hardware and computer instructions.

While the subject matter has been described above in the general context of computer-executable instructions of a computer program product that runs on a computer or computers, those skilled in the art will recognize that this disclosure also can or can be implemented in combination with other program modules. Generally, program modules include routines, programs, components, data structures, etc. that perform particular tasks or implement particular abstract data types. Moreover, those skilled in the art will appreciate that various aspects can be practiced with other computer system configurations, including single-processor or multiprocessor computer systems, mini-computing devices, mainframe computers, as well as computers, hand-held computing devices (e.g., PDA, phone), microprocessor-based or programmable consumer or industrial electronics, and the like. The illustrated aspects can also be practiced in distributed computing environments in which tasks are performed by remote processing devices that are linked through a communications network. However, some, if not all aspects of this disclosure can be practiced on stand-alone computers. In a distributed computing environment, program modules can be located in both local and remote memory storage devices.

As used in this application, the terms "component," "system," "platform," "interface," and the like, can refer to or can include a computer-related entity or an entity related to an operational machine with one or more specific functionalities. The entities disclosed herein can be either hardware, a combination of hardware and software, software, or software in execution. For example, a component can be, but is not limited to being, a process running on a processor, a processor, an object, an executable, a thread of execution, a program, or a computer. By way of illustration, both an application running on a server and the server can be a component. One or more components can reside within a process or thread of execution and a component can be localized on one computer or distributed between two or more computers. In another example, respective components can execute from various computer readable media having various data structures stored thereon. The components can communicate via local or remote processes such as in accordance with a signal having one or more data packets (e.g., data from one component interacting with another component in a local system, distributed system, or across a network such as the Internet with other systems via the signal). As another example, a component can be an apparatus with specific functionality provided by mechanical parts operated by electric or electronic circuitry, which is operated by a software or firmware application executed by a processor. In such a case, the processor can be internal or external to the apparatus and can execute at least a part of the software or firmware application. As yet another example, a component can be an apparatus that provides specific functionality through electronic components without mechanical parts, wherein the electronic components can include a processor or other means to execute software or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. As used herein, the term "and/or" is intended to have the same meaning as "or." Moreover, articles "a" and "an" as used in the subject specification and annexed drawings should generally be construed to mean "one or more" unless specified otherwise or clear from context to be directed to a singular form. As used herein, the terms "example" or "exemplary" are utilized to mean serving as an example, instance, or illustration. For the avoidance of doubt, the subject matter disclosed herein is not limited by such examples. In addition, any aspect or design described herein as an "example" or "exemplary" is not necessarily to be construed as preferred or advantageous over other aspects or designs, nor is it meant to preclude equivalent exemplary structures and techniques known to those of ordinary skill in the art.

The herein disclosure describes non-limiting examples. For ease of description or explanation, various portions of the herein disclosure utilize the term "each," "every," or "all" when discussing various examples. Such usages of the term "each," "every," or "all" are non-limiting. In other words, when the herein disclosure provides a description that is applied to "each," "every," or "all" of some particular object or component, it should be understood that this is a non-limiting example, and it should be further understood that, in various other examples, it can be the case that such description applies to fewer than "each," "every," or "all" of that particular object or component.

As it is employed in the subject specification, the term "processor" can refer to substantially any computing processing unit or device comprising, but not limited to, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, or any combination thereof designed to perform the functions described herein. Further, processors can exploit nano-scale architectures such as, but not limited to, molecular and quantum-dot based transistors, switches and gates, in order to optimize space usage or enhance performance of user equipment. A processor can also be implemented as a combination of computing processing units. In this disclosure, terms such as "store," "storage," "data store," data storage," "database," and substantially any other information storage component relevant to operation and functionality of a component are utilized to refer to "memory components," entities embodied in a "memory," or components comprising a memory. It is to be appreciated that memory or memory components described herein can be either volatile memory or nonvolatile memory, or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory, or nonvolatile random access memory (RAM) (e.g., ferroelectric RAM (FeRAM). Volatile memory can include RAM, which can act as external cache memory, for example. By way of illustration and not limitation, RAM is available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM), and Rambus dynamic RAM (RDRAM). Additionally, the disclosed memory components of systems or computer-implemented methods herein are intended to include, without being limited to including, these and any other suitable types of memory.

What has been described above include mere examples of systems and computer-implemented methods. It is, of course, not possible to describe every conceivable combination of components or computer-implemented methods for purposes of describing this disclosure, but many further combinations and permutations of this disclosure are possible. Furthermore, to the extent that the terms "includes," "has," "possesses," and the like are used in the detailed description, claims, appendices and drawings such terms are intended to be inclusive in a manner similar to the term "comprising" as "comprising" is interpreted when employed as a transitional word in a claim.

The descriptions of the various embodiments have been presented for purposes of illustration, but are not intended to be exhaustive or limited to the embodiments disclosed. Many modifications and variations will be apparent without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

Various non-limiting aspects are described in the following examples.

EXAMPLE 1: A scientific instrument can comprise a processor that can execute computer-executable components stored in a non-transitory computer-readable memory. In various aspects, the computer-executable components can comprise an access component that can access a digital twin of the scientific instrument. In various instances, the computer-executable components can comprise a calibration component that can synchronize, via execution of a state-wide Bayesian filter, a parametric state of the digital twin with a physical state of the scientific instrument.

EXAMPLE 2: The scientific instrument of any preceding example can be implemented, wherein the state-wide Bayesian filter can comprise a set of calibration iterations, each of which can comprise a Bayesian update to an entirety of the parametric state based on an iteration-common observable that is exhibitable by the scientific instrument and simulatable by the digital twin.

EXAMPLE 3: The scientific instrument of any preceding example can be implemented, wherein, during a current calibration iteration of the set of calibration iterations, the calibration component can: measure an observation of the iteration-common observable that is exhibited during operation of the scientific instrument; randomly sample a plurality of parametric state instantiations from a state-space of the digital twin, wherein the state-space can be incrementally constrained via recursive Bayesian updating based on a previous calibration iteration; compute, based on running the plurality of parametric state instantiations on the digital twin, a plurality of simulated observations of the iteration-common observable; respectively assign weights to the plurality of parametric state instantiations, based on differences between the observation and the plurality of simulated observations; delete whichever of the plurality of parametric state instantiations have weights below a threshold weight value, thereby yielding a plurality of remaining parametric state instantiations; check whether a variance of the plurality of remaining parametric state instantiations is below a threshold variance value; determine, in response to a determination that the variance of the plurality of remaining parametric state instantiations is below the threshold variance value, that the parametric state of the digital twin and the physical state of the scientific instrument are synchronized at a weighted average of the plurality of remaining parametric state instantiations; apply, in response to a determination that the variance of the plurality of remaining parametric state instantiations is not below the threshold variance value, an active settings adjustment to the scientific instrument; and modify the plurality of remaining parametric state instantiations based on the active settings adjustment, thereby yielding a plurality of modified remaining parametric state instantiations, wherein the plurality of modified remaining parametric state instantiations are used to incrementally constrain the state-space via recursive Bayesian updating during a following calibration iteration.

EXAMPLE 4: The scientific instrument of any preceding example can be implemented, wherein the calibration component can further modify the plurality of remaining parametric state instantiations based on a passive temporal evolution associated with the scientific instrument.

EXAMPLE 5: The scientific instrument of any preceding example can be implemented, wherein the scientific instrument can be a charged-particle microscope.

EXAMPLE 6: The scientific instrument of any preceding example can be implemented, wherein the parametric state of the digital twin can be an aberration coefficient vector of the charged-particle microscope.

EXAMPLE 7: The scientific instrument of any preceding example can be implemented, wherein the iteration-common observable can be based on a convergent beam electron diffraction pattern of an amorphous carbon specimen captured by the charged-particle microscope.

EXAMPLE 8: The scientific instrument of any preceding example can be implemented, wherein the active settings adjustment can be a lens setting adjustment, a deflector setting adjustment, a temperature setting adjustment, or a stage actuator adjustment of the charged-particle microscope.

EXAMPLE 9: The scientific instrument of any preceding example can be implemented, wherein the state-wide Bayesian filter can be based on a particle filter technique or a Kalman filter technique.

In various embodiments, any combination or combinations of examples 1-9 can be implemented.

EXAMPLE 10: A computer-implemented method can comprise synchronizing, by a device operatively coupled to a processor that executes a state-wide Bayesian filter, a parametric state of a digital twin with a physical state of a scientific instrument. In various aspects, the computer-implemented method can comprise generating, by the device and in response to the synchronizing, an electronic alert indicating that the digital twin is ready to forecast behavior of the scientific instrument.

EXAMPLE 11: The computer-implemented method of any preceding example can be implemented, wherein the state-wide Bayesian filter can comprise a set of calibration iterations, each of which can comprise a Bayesian update to an entirety of the parametric state based on an iteration-common observable that is exhibitable by the scientific instrument and simulatable by the digital twin.

EXAMPLE 12: The computer-implemented method of any preceding example can be implemented, wherein a current calibration iteration of the set of calibration iterations can comprise: measuring, by the device, an observation of the iteration-common observable that is exhibited during operation of the scientific instrument; randomly sampling, by the device, a plurality of parametric state instantiations from a state-space of the digital twin, wherein the state-space can be incrementally constrained via recursive Bayesian updating based on a previous calibration iteration; computing, by the device and based on running the plurality of parametric state instantiations on the digital twin, a plurality of simulated observations of the iteration-common observable; respectively assigning, by the device, weights to the plurality of parametric state instantiations, based on differences between the observation and the plurality of simulated observations; deleting, by the device, whichever of the plurality of parametric state instantiations have weights below a threshold weight value, thereby yielding a plurality of remaining parametric state instantiations; checking, by the device, whether a variance of the plurality of remaining parametric state instantiations is below a threshold variance value; determining, by the device and in response to a determination that the variance of the plurality of remaining parametric state instantiations is below the threshold variance value, that the parametric state of the digital twin and the physical state of the scientific instrument are synchronized at a weighted average of the plurality of remaining parametric state instantiations; applying, by the device and in response to a determination that the variance of the plurality of remaining parametric state instantiations is not below the threshold variance value, an active settings adjustment to the scientific instrument; and modifying, by the device, the plurality of remaining parametric state instantiations based on the active settings adjustment, thereby yielding a plurality of modified remaining parametric state instantiations, wherein the plurality of modified remaining parametric state instantiations can be used to incrementally constrain the state-space via recursive Bayesian updating during a following calibration iteration.

EXAMPLE 13: The computer-implemented method of any preceding example can be implemented, wherein the device can further modify the plurality of remaining parametric state instantiations based on a passive temporal evolution associated with the scientific instrument.

EXAMPLE 14: The computer-implemented method of any preceding example can be implemented, wherein the scientific instrument can be a charged-particle microscope.

EXAMPLE 15: The computer-implemented method of any preceding example can be implemented, wherein the parametric state of the digital twin can be an aberration coefficient vector of the charged-particle microscope.

EXAMPLE 16: The computer-implemented method of any preceding example can be implemented, wherein the iteration-common observable can be based on a convergent beam electron diffraction pattern of an amorphous carbon specimen captured by the charged-particle microscope.

EXAMPLE 17: The computer-implemented method of any preceding example can be implemented, wherein the active settings adjustment can be a lens setting adjustment, a deflector setting adjustment, a temperature setting adjustment, or a stage actuator adjustment of the charged-particle microscope.

In various embodiments, any combination or combinations of examples 10-17 can be implemented.

EXAMPLE 18: A computer program product for facilitating improved digital twin calibration for scientific instruments can comprise a non-transitory computer-readable memory having program instructions embodied therewith. In various aspects, the program instructions can be executable by a processor to cause the processor to: access a digital twin of a charged-particle microscope; synchronize a parametric state of the digital twin with a physical state of the charged-particle microscope, via execution of a set of calibration iterations, each of which can comprise a Bayesian update to an entirety of the parametric state based on an iteration-common observable that is exhibitable by the charged-particle microscope and simulatable by the digital twin; and forecast, by running the digital twin after synchronization, how the charged-particle microscope would respond to a proposed usage scenario.

EXAMPLE 19: The computer program product of any preceding example can be implemented, wherein the parametric state of the charged-particle microscope can be an aberration coefficient vector.

EXAMPLE 20: The computer program product of any preceding example can be implemented, wherein the iteration-common observable can be based on a convergent beam electron diffraction pattern of an amorphous carbon specimen.

In various embodiments, any combination or combinations of examples 18-20 can be implemented.

In various embodiments, any combination or combinations of examples 1-20 can be implemented.

## Claims

1. A computer-implemented method, comprising:
synchronizing, by a device operatively coupled to a processor that executes a state-wide Bayesian filter, a parametric state of a digital twin with a physical state of a scientific instrument; and
generating, by the device and in response to the synchronizing, an electronic alert indicating that the digital twin is ready to forecast behavior of the scientific instrument.

2. The computer-implemented method of claim 1, wherein the state-wide Bayesian filter comprises a set of calibration iterations, each of which comprises a Bayesian update to an entirety of the parametric state based on an iteration-common observable that is exhibitable by the scientific instrument and simulatable by the digital twin.

3. The computer-implemented method of claim 1, wherein a current calibration iteration of the set of calibration iterations comprises:
measuring, by the device, an observation of the iteration-common observable that is exhibited during operation of the scientific instrument;
randomly sampling, by the device, a plurality of parametric state instantiations from a state-space of the digital twin, wherein the state-space is incrementally constrained via recursive Bayesian updating based on a previous calibration iteration;
computing, by the device and based on running the plurality of parametric state instantiations on the digital twin, a plurality of simulated observations of the iteration-common observable;
respectively assigning, by the device, weights to the plurality of parametric state instantiations, based on differences between the observation and the plurality of simulated observations;
deleting, by the device, whichever of the plurality of parametric state instantiations have weights below a threshold weight value, thereby yielding a plurality of remaining parametric state instantiations;
checking, by the device, whether a variance of the plurality of remaining parametric state instantiations is below a threshold variance value;
determining, by the device and in response to a determination that the variance of the plurality of remaining parametric state instantiations is below the threshold variance value, that the parametric state of the digital twin and the physical state of the scientific instrument are synchronized at a weighted average of the plurality of remaining parametric state instantiations;
applying, by the device and in response to a determination that the variance of the plurality of remaining parametric state instantiations is not below the threshold variance value, an active settings adjustment to the scientific instrument; and
modifying, by the device, the plurality of remaining parametric state instantiations based on the active settings adjustment, thereby yielding a plurality of modified remaining parametric state instantiations, wherein the plurality of modified remaining parametric state instantiations are used to incrementally constrain the state-space via recursive Bayesian updating during a following calibration iteration.

4. The computer-implemented method of claim 3, wherein the device further modifies the plurality of remaining parametric state instantiations based on a passive temporal evolution associated with the scientific instrument.

5. The computer-implemented method of claim 3 or claim 4, wherein the scientific instrument is a charged-particle microscope.

6. The computer-implemented method of claim 5, wherein the parametric state of the digital twin is an aberration coefficient vector of the charged-particle microscope.

7. The computer-implemented method of claim 5, wherein the iteration-common observable is based on a convergent beam electron diffraction pattern of an amorphous carbon specimen captured by the charged-particle microscope.

8. The computer-implemented method of any one of claims 5, 6 or 7, wherein the active settings adjustment is a lens setting adjustment, a deflector setting adjustment, a temperature setting adjustment, or a stage actuator adjustment of the charged-particle microscope.

9. The computer-implemented method of any one of claims 5-8 when dependent upon claim 2, further comprising
forecasting, by running the digital twin after synchronization, how the charged-particle microscope would respond to a proposed usage scenario.

10. The computer implemented method of claim 9, wherein the parametric state of the charged-particle microscope is an aberration coefficient vector.

11. The computer implemented method of claim 10, wherein the iteration-common observable is based on a convergent beam electron diffraction pattern of an amorphous carbon sample.

12. A computer program comprising program code which, when executed, cause a processor to carry out the method steps of any one of claims 1-11.

13. A computer program product comprising a non transitory computer readable memory within which is embodied the computer program of claim 12.

14. A scientific instrument comprising a non transitory computer readable memory within which is stored the computer program of claim 12, and a processor configured to execute the program code of the said computer program.
